# EUROPEAN PATENT APPLICATION

(11) **EP 4 665 128 A1**
(43) Date of publication of application: **17.12.2025**
(21) Application number: 24795700.4
(22) Date of filing: 19.03.2024
(51) Int. Cl.: H10K 59/131, H10K 59/121

(54) **DISPLAY PANEL AND MANUFACTURING METHOD THEREFOR, AND DISPLAY DEVICE**

(30) Priority: 27.04.2023 CN 202310476758
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: FAN, Cong, Beijing 100176 (CN); DU, Mengmeng, Beijing 100176 (CN); DONG, Xiangdan, Beijing 100176 (CN); WANG, Rong, Beijing 100176 (CN)
(74) Representative: CMS Cameron McKenna Nabarro Olswang LLP
(86) International application number: PCT/CN2024/082374
(87) International publication number: WO 2024/222317

(57) **Abstract**

A display panel, comprising a substrate, a display structure layer located in a display area, a plurality of data leads located in a signal access area, a plurality of contact pads, and an inorganic composite insulating layer. At least one contact pad comprises a plurality of contact pad metal layers electrically connected to each other, and the plurality of contact pad metal layers are electrically connected to one of the plurality of data leads. The inorganic composite insulating layer is located on the side of at least one of the plurality of contact pad metal layers close to the substrate. The orthographic projection of the inorganic composite insulating layer on the substrate does not overlap the orthographic projections of the plurality of contact pads on the substrate, or the orthographic projection of the inorganic composite insulating layer on the substrate at least partially overlaps the orthographic projection of the at least one contact pad on the substrate.

## Description

The present application claims priority to Chinese patent application No. 202310476758.1, filed to the CNIPA on April 27, 2023 and entitled "Display Panel and Manufacturing Method Therefor, and Display Device", the contents of which should be construed as being incorporated into the present application by reference.

### Technical Field

The present disclosure relates to, but is not limited to, the field of display technologies, and particularly to a display panel and a manufacturing method therefor, and a display device.

### Background

An organic light emitting diode (OLED) is an active light emitting display device and has advantages such as self-luminescence, a wide viewing angle, a high contrast ratio, low power consumption, an extremely high response speed, etc. With continuous development of display technologies, a display device in which an OLED is used as a light emitting device and signal control is performed by a thin film transistor (TFT) has become a mainstream product in the field of display at present.

### Summary

The following is a summary of subject matters described herein in detail. This summary is not intended to limit the protection scope according to claims.

Embodiments of the present disclosure provide a display panel, a manufacturing method for the display panel, and a display device.

In one aspect, the present embodiment provides a display panel including a base substrate, a display structure layer, a plurality of data leads, a plurality of contact pads, and an inorganic composite insulation layer. The base substrate includes a display region and a signal access region located on at least one side of the display region. The display structure layer is located on the base substrate of the display region, and includes a plurality of sub-pixels and a plurality of data lines, and the plurality of sub-pixels and the plurality of data lines are electrically connected. The plurality of data lines are configured to provide data signals to the plurality of sub-pixels. The plurality of data leads are located in the signal access region, and the plurality of data leads are connected to the plurality of data lines. The plurality of contact pads are located in the signal access region, and at least one contact pad includes a plurality of contact pad metal layers electrically connected to each other. The plurality of contact pad metal layers are electrically connected to one of the plurality of data leads. The inorganic composite insulation layer is located in the signal access region and is located on a side of at least one contact pad metal layer of the plurality of contact pad metal layers close to the base substrate. An orthographic projection of the inorganic composite insulation layer on the base substrate does not overlap with orthographic projections of the plurality of contact pads on the base substrate, or the orthographic projection of the inorganic composite insulation layer on the base substrate at least partially overlaps with an orthographic projection of the at least one contact pad on the base substrate.

In some exemplary embodiments, the inorganic composite insulation layer is located on a side of the plurality of contact pad metal layers close to the base substrate.

In some exemplary embodiments, the orthographic projection of the inorganic composite insulation layer on the base substrate covers orthographic projections of overlapping regions of the plurality of contact pad metal layers on the base substrate.

In some exemplary embodiments, at least a part of the inorganic composite insulation layer is located in a gap between adjacent contact pads.

In some exemplary embodiments, the at least one contact pad further includes an inactive contact pad metal layer. The inorganic composite insulation layer is located between the plurality of contact pad metal layers and the inactive contact pad metal layer of the at least one contact pad.

In some exemplary embodiments, the orthographic projection of the inorganic composite insulation layer on the base substrate covers an orthographic projection of the inactive contact pad metal layer on the base substrate.

In some exemplary embodiments, the at least one contact pad includes: a first contact pad metal layer in contact with a surface of the inorganic composite insulation layer away from the base substrate. The first contact pad metal layer is electrically connected to one data lead.

In some exemplary embodiments, the first contact pad metal layer and the one data lead are of an integral structure connected to each other.

In some exemplary embodiments, the display panel further includes a plurality of access connection lines located in the signal access region. The first contact pad metal layer is electrically connected to the data lead through one access connection line; and the first contact pad metal layer and the one access connection line are of an integral structure connected to each other.

In some exemplary embodiments, a connection position of the access connection line and the data lead is located on a side of the plurality of contact pads close to the display region.

In some exemplary embodiments, the display panel further includes a plurality of connection electrodes located in the signal access region. The access connection line is electrically connected to the data lead through a connection electrode; the access connection line is located on a side of the data lead away from the base substrate; and the connection electrode is located on a side of the access connection line away from the base substrate.

In some exemplary embodiments, at least one sub-pixel of the plurality of sub-pixels includes a pixel circuit; the pixel circuit includes at least one first transistor and at least one second transistor; and the first transistor and the second transistor have different transistor types. The first transistor includes a first active layer and a first gate. The second transistor includes a second active layer and a second gate; the first active layer and the first gate of the first transistor are located on a side of the second active layer of the second transistor close to the base substrate; and the second gate is located on a side of the second active layer away from the base substrate. A third gate insulation layer is provided between the second active layer and the second gate. The inorganic composite insulation layer at least includes a fifth inorganic insulation layer arranged in the same layer as the third gate insulation layer.

In some exemplary embodiments, the pixel circuit further includes at least one capacitor; the capacitor includes a first plate and a second plate; the second plate is located on a side of the first plate away from the base substrate and located on the side of the second active layer of the second transistor close to the base substrate. A first interlayer insulation layer is provided between the second plate and the second active layer of the second transistor; and the inorganic composite insulation layer includes the fifth inorganic insulation layer and a third inorganic insulation layer arranged in the same layer as the first interlayer insulation layer.

In some exemplary embodiments, a first buffer layer is further provided between the second plate and the second active layer of the second transistor, and the first interlayer insulation layer is located on a side of the first buffer layer close to the base substrate. The inorganic composite insulation layer includes the third inorganic insulation layer, the fifth inorganic insulation layer, and a fourth inorganic insulation layer arranged in the same layer as the first buffer layer.

In some exemplary embodiments, the at least one contact pad includes: a first contact pad metal layer in contact with a surface of the inorganic composite insulation layer away from the base substrate; and the first contact pad metal layer and a second gate of the second transistor are structures arranged in a same layer.

In some exemplary embodiments, the at least one contact pad further includes a second contact pad metal layer located on a side of the first contact pad metal layer away from the base substrate. The display panel further includes a sixth inorganic insulation layer located in the signal access region and located on a side of the fifth inorganic insulation layer away from the base substrate. An orthographic projection of the sixth inorganic insulation layer on the base substrate does not overlap with the orthographic projection of the at least one contact pad on the base substrate; or, the sixth inorganic insulation layer covers an edge of the first contact pad metal layer of the at least one contact pad, and a surface of the first contact pad metal layer exposed by the sixth inorganic insulation layer is in contact with the second contact pad metal layer.

In some exemplary embodiments, a part of the sixth inorganic insulation layer is disposed in a gap between adjacent contact pads.

In some exemplary embodiments, the sixth inorganic insulation layer has an annular structure covering an edge of the first contact pad metal layer.

In some exemplary embodiments, the second transistor further includes a second source and a second drain, and a second interlayer insulation layer is provided between the second gate of the second transistor and the second source and the second drain of the second transistor. The sixth inorganic insulation layer is arranged in the same layer as the second interlayer insulation layer. The second contact pad metal layer and the second source and the second drain of the second transistor are structures arranged in a same layer.

In some exemplary embodiments, the at least one contact pad includes a first contact pad metal layer located on a side of the inorganic composite insulation layer close to the base substrate, and a second contact pad metal layer located on a side of the inorganic composite insulation layer away from the base substrate, and the second contact pad metal layer is connected to the first contact pad metal layer. The inorganic composite insulation layer covers an edge of the first contact pad metal layer.

In some exemplary embodiments, the inorganic composite insulation layer has an annular structure covering an edge of the first contact pad metal layer.

In some exemplary embodiments, the at least one sub-pixel further includes a light emitting element, and the pixel circuit is electrically connected to the light emitting element through a first transfer electrode. The at least one contact pad includes a first contact pad metal layer, a second contact pad metal layer, and a third contact pad metal layer sequentially arranged along a direction away from the base substrate. The third contact pad metal layer and the first transfer electrode are structures arranged in a same layer.

In some exemplary embodiments, the display panel further includes a touch structure layer located on a side of the display structure layer away from the base substrate, and the touch structure layer includes at least one touch conductive layer. The at least one contact pad further includes a fourth contact pad metal layer located on a side of the third contact pad metal layer away from the base substrate, and the fourth contact pad metal layer and one touch conductive layer of the touch structure layer are structures arranged in a same layer.

In some exemplary embodiments, a side edge of the inorganic composite insulation layer is in contact with the second contact pad metal layer or the third contact pad metal layer.

In some exemplary embodiments, the display panel further includes a first organic insulation layer located in the signal access region and located on a side of the inorganic composite insulation layer away from the base substrate; a side edge of the inorganic composite insulation layer is in contact with the first organic insulation layer.

In another aspect, the present embodiment provides a display device, including the aforementioned display panel.

In another aspect, the present embodiment provides a manufacturing method for a display panel, including: providing a base substrate, the base substrate including a display region and a signal access region located on at least one side of the display region; and forming a display structure layer in the display region, and forming a plurality of data leads, a plurality of contact pads and an inorganic composite insulation layer in the signal access region. The display structure layer includes a plurality of sub-pixels and a plurality of data lines, and the plurality of sub-pixels and the plurality of data lines are electrically connected. The plurality of data lines are configured to provide data signals to the plurality of sub-pixels; the plurality of data leads are connected to the plurality of data lines; at least one contact pad of the plurality of contact pads includes a plurality of contact pad metal layers electrically connected to each other, and the plurality of contact pad metal layers are electrically connected to one of the plurality of data leads. The inorganic composite insulation layer is located on a side of at least one contact pad metal layer of the plurality of contact pad metal layers close to the base substrate; an orthographic projection of the inorganic composite insulation layer on the base substrate does not overlap with orthographic projections of the plurality of contact pads on the base substrate, or the orthographic projection of the inorganic composite insulation layer on the base substrate at least partially overlaps with an orthographic projection of the at least one contact pad on the base substrate.

In another aspect, the present embodiment provides a display panel including a base substrate, a display structure layer, a plurality of data leads, a plurality of contact pads, an inorganic composite insulation layer, and a first organic insulation layer. The base substrate includes a display region and a signal access region located on at least one side of the display region. The display structure layer is located on the base substrate of the display region, and the display structure layer includes a plurality of sub-pixels and a plurality of data lines electrically connected to the plurality of sub-pixels, and the plurality of data lines are configured to provide data signals to the plurality of sub-pixels. The plurality of data leads are located in the signal access region, and the plurality of data leads are connected to the plurality of data lines. The plurality of contact pads are located in the signal access region, at least one contact pad of the plurality of contact pads includes a plurality of contact pad metal layers electrically connected to each other, and the plurality of contact pad metal layers are electrically connected to one of the plurality of data leads. The inorganic composite insulation layer is located in the signal access region, and the inorganic composite insulation layer is located on a side of at least one contact pad metal layer of the plurality of contact pad metal layers close to the base substrate. The first organic insulation layer is located in the signal access region, and the first organic insulation layer is located on a side of the inorganic composite insulation layer and the at least one contact pad metal layer of the plurality of contact pad metal layers away from the base substrate. A side edge of the inorganic composite insulation layer is in contact with the first organic insulation layer or one of the plurality of contact pad metal layers.

In some exemplary embodiments, the inorganic composite insulation layer is located on a side of the plurality of contact pad metal layers close to the base substrate, and an orthographic projection of the inorganic composite insulation layer on the base substrate covers orthographic projections of overlapping regions of the plurality of contact pad metal layers on the base substrate.

In some exemplary embodiments, the at least one contact pad further includes an inactive contact pad metal layer. The inorganic composite insulation layer is located between the plurality of contact pad metal layers and the inactive contact pad metal layer of the at least one contact pad.

Other aspects of the present disclosure may be comprehended after the drawings and the detailed descriptions are read and understood.

### Brief Description of Drawings

Accompanying drawings are used for providing further understanding of technical solutions of the present disclosure, constitute a portion of the specification, and are used for explaining the technical solutions of the present disclosure together with embodiments of the present disclosure, but do not constitute limitations on the technical solutions of the present disclosure. Shapes and sizes of one or more components in the drawings do not reflect actual scales, but are only intended to schematically describe contents of the present disclosure.
FIG. 1A is a schematic view of a display panel according to at least one embodiment of the present disclosure.
FIG. 1B is another schematic view of a display panel according to at least one embodiment of the present disclosure.
FIG. 2 is a schematic partial cross-sectional view of a display region of a display panel according to at least one embodiment of the present disclosure.
FIG. 3 is a schematic partial view of a signal access region according to at least one embodiment of the present disclosure.
FIG. 4 is an example of a partial cross-sectional view taken along a direction P-P' in FIG. 3.
FIG. 5 is a partially enlarged schematic view of a region S1 in FIG. 3.
FIG. 6A is a schematic view of a first gate metal layer in FIG. 5.
FIG. 6B is a schematic view of a third gate metal layer in FIG. 5.
FIG. 7 is a schematic partial cross-sectional view taken along a direction Q-Q' in FIG. 5.
FIG. 8 is an example of a partially enlarged view of a region S2 in FIG. 3.
FIG. 9 is another schematic partial cross-sectional view taken along the direction P-P' in FIG. 3.
FIG. 10 is another example of a partially enlarged view of the region S2 in FIG. 3.
FIG. 11 is another schematic partial cross-sectional view taken along the direction P-P' in FIG. 3.
FIG. 12 is another schematic partial cross-sectional view taken along the direction P-P' in FIG. 3.
FIG. 13 is another example of a partially enlarged view of the region S1 in FIG. 3.
FIG. 14A is a schematic view of a third gate metal layer in FIG. 13.
FIG. 14B is a schematic view of a first gate metal layer in FIG. 13.
FIG. 15 is a schematic partial cross-sectional view taken along a direction R-R' in FIG. 13.
FIG. 16 is another example of a partial cross-sectional view taken along the direction P-P' in FIG. 3.
FIG. 17 is another example of a partial cross-sectional view taken along the direction P-P' in FIG. 3.
FIG. 18 is another schematic partial view of a signal access region according to at least one embodiment of the present disclosure.
FIG. 19 is a schematic view of a first gate metal layer in FIG. 18.
FIG. 20 is a schematic partial cross-sectional view taken along a direction V-V' in FIG. 18.
FIG. 21 is a partially enlarged schematic view of a region S3 in FIG. 18.
FIG. 22 is another example of a partial cross-sectional view taken along the direction V-V' in FIG. 18.
FIG. 23 is a schematic view of a display device according to at least one embodiment of the present disclosure.

### Detailed Description

The embodiments of the present disclosure will be described below with reference to the drawings in detail. Implementations may be implemented in multiple different forms. Those of ordinary skills in the art may easily understand such a fact that implementations and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one implementation of the present disclosure is not necessarily limited to the size, and a shape and a size of one or more components in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third" and the like in the specification are set not to form limits in numbers but only to avoid confusion between constituent elements. In the present disclosure, "multiple/a plurality of" represents two or more than two.

In the specification, for convenience, expressions "central", "above", "below", "front", "back", "vertical", "horizontal", "top", "bottom", "inside", "outside" and the like for indicating directional or positional relationships are used to illustrate positional relationships between the constituent elements with reference to the accompanying drawings, not to indicate or imply that involved devices or elements are required to have specific orientations or are structured and operated in the specific orientations but only to easily describe the present specification and simplify the description, and thus should not be understood as limitations on the present disclosure. The positional relationships between the constituent elements are changed as appropriate according to directions of the constituent elements described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, it may be a fixed connection, a detachable connection, or an integral connection; it may be a mechanical connection or a connection; it may be a direct connection, an indirect connection through a middleware, or an internal communication between two elements. Those of ordinary skills in the art may understand meanings of the aforementioned terms in the present disclosure according to situations.

In the specification, an "electrical connection" includes a case that constituent elements are connected together through an element with a certain electrical action. The "element with a certain electrical action" is not particularly limited as long as electrical signals between the connected constituent elements may be transmitted. Examples of the "element with a certain electrical action" not only include an electrode and a wiring, but also include a switching element such as a transistor, a resistor, an inductor, a capacitor, another element with various functions, etc.

In the specification, a transistor refers to an element which at least includes three terminals, i.e., a gate, a drain, and a source. The transistor has a channel region between the drain (drain electrode terminal, drain region, or drain electrode) and the source (source electrode terminal, source region, or source electrode), and a current can flow through the drain, the channel region, and the source. In the specification, the channel region refers to a region through which a current mainly flows.

In the specification, a first pole may be a drain and a second pole may be a source, or, a first pole may be a source and a second pole may be a drain. In a case that transistors with opposite polarities are used, or in a case that a direction of a current is changed during operation of a circuit, or the like, functions of the "source" and the "drain" are sometimes interchangeable. Therefore, the "source" and the "drain" are interchangeable in the specification. In addition, the gate may also be referred to as a control electrode.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In this specification, a circle, oval, triangle, rectangle, trapezoid, pentagon or hexagon or the like is not strictly speaking, but may be an approximate circle, oval, triangle, rectangle, trapezoid, pentagon or hexagon or the like. Some small deformations due to tolerances may exist, for example, chamfers, curved edges and deformations may exist.

In the present disclosure, "about" and "substantially" means that a boundary is not defined strictly and a case within a range of process and measurement errors is allowed. In the present disclosure, "substantially the same" refers to a case where numerical values differ by less than 10%. "Symmetry" in the present disclosure means that a boundary is not defined strictly and a case where approximate symmetry within a range of process and measurement errors is allowed.

In the present disclosure, "A extends along a B direction" means that A may include a main body portion and a secondary portion connected to the main body portion. The main body portion is a line, a line segment, or a strip-shaped body, the main body portion extends along the B direction, and a length of the main body portion extending along the B direction is greater than a length of the secondary portion extending along another direction. "A extends along the B direction" in the present disclosure always means "the main portion of A extends along the B direction". In the present disclosure, A and B being of an integral structure means that A and B are connected to each other and formed integrally.

Generally, after the preparation process of the display panel, it is necessary to connect the display panel to an external circuit (for example, a circuit such as a control chip) to control or drive the display panel through the external circuit during the display process. For example, the external circuit may include a flexible circuit board on which a control chip or a drive chip or the like is disposed. Contact pads are provided on the display panel to connect to the circuit of the flexible circuit board by a bonding process. If there is a height difference between the contact pad of the display panel and its peripheral region, for example, the height of the inorganic film layer in the peripheral region is large, then the pressure exerted by the pressure head of the device for providing pressure on the display panel in the bonding process is unevenly distributed. The display panel may break due to uneven stress. For example, the inorganic film layer in the gap portion between the contact pads may break under the action of tensile stress caused by uneven stress, thus damaging the display panel.

For example, in the manufacturing process of a display panel, a film layer included in the display panel, such as an insulation layer, in which crystals typically have defects in microstructure, may be formed by physical or chemical vapor deposition, such as Plasma Enhanced Chemical Vapor Deposition (PECVD). In the actual process, when there is a height difference between the contact pad and its peripheral region, the stress in the bonding region will be uneven in the bonding process, resulting in stress concentration. For example, the stress concentration in the region where the tips (e.g. corners) of the contact pad are located can exacerbate crystal defects in the film layer, further making the film layer susceptible to break.

The present embodiment provides a display panel including a base substrate, a display structure layer, a plurality of data leads, a plurality of contact pads, and an inorganic composite insulation layer. The base substrate includes a display region and a signal access region located on at least one side of the display region. The display structure layer is located on the base substrate of the display region and includes a plurality of sub-pixels and a plurality of data lines, the plurality of sub-pixels and the plurality of data lines are electrically connected, and the plurality of data lines are configured to provide data signals to the plurality of sub-pixels. The plurality of data leads are located in the signal access region, and the plurality of data leads are connected to the plurality of data lines. The plurality of contact pads are located in the signal access region, and at least one contact pad includes a plurality of contact pad metal layers electrically connected to each other. The plurality of contact pad metal layers are electrically connected to one of the plurality of data leads. The inorganic composite insulation layer is located in the signal access region and is located on a side of at least one contact pad metal layer of the plurality of contact pad metal layers close to the base substrate. An orthographic projection of the inorganic composite insulation layer on the base substrate does not overlap with orthographic projections of the plurality of contact pads on the base substrate, or the orthographic projection of the inorganic composite insulation layer on the base substrate at least partially overlaps with an orthographic projection of at least one contact pad on the base substrate.

In the display panel provided by the present embodiment, by providing the inorganic composite insulation layer or removing the inorganic composite insulation layer, the height difference between the contact pad and a peripheral film layer can be reduced, thereby alleviating the crack of the film layers existing in the bonding process, and improving the stability of the bonding process and the product yield of the display panel.

In some exemplary implementations, the inorganic composite insulation layer may be located on a side of the plurality of contact pad metal layers close to the base substrate. In some examples, an orthographic projection of the inorganic composite insulation layer on the base substrate may cover orthographic projections of overlapping regions of the plurality of contact pad metal layers on the base substrate. In this example, the inorganic composite insulation layer can be used to raise the contact pad metal layer, thereby reducing the height difference between the contact pad and the peripheral film layer, alleviating the crack of the film layers existing in the bonding process, and improving the stability of the bonding process and the product yield of the display panel.

In some exemplary implementations, the at least one contact pad may further include an inactive contact pad metal layer. The inorganic composite insulation layer may be located between the plurality of contact pad metal layers and the inactive contact pad metal layer of the contact pad. In this example, the inactive contact pad metal layer is used to raise the contact pad metal layer, thereby reducing the height difference between the contact pad and the peripheral film layer, alleviating the crack of the film layers existing in the bonding process, and improving the stability of the bonding process and the product yield of the display panel.

Solutions of this embodiment will be described below through a plurality of examples.

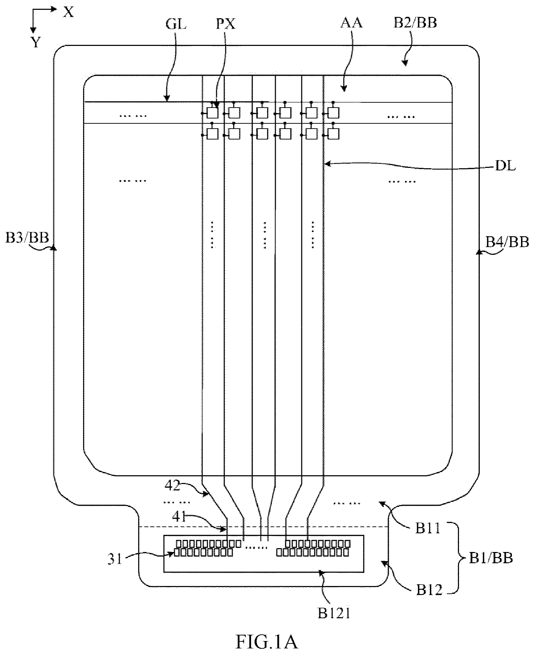

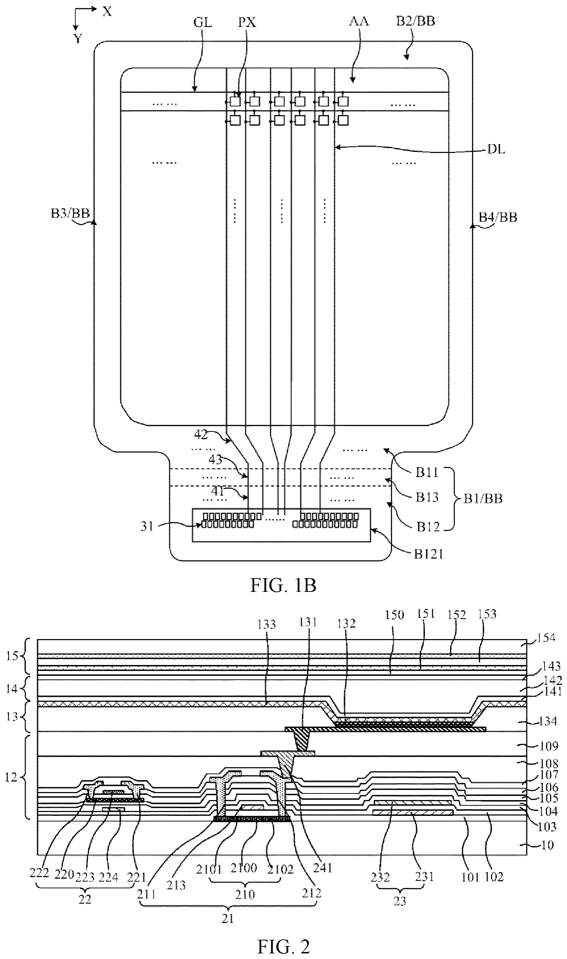

FIG. 1A is a schematic view of a display panel according to at least one embodiment of the present disclosure. FIG. 1B is another schematic view of a display panel according to at least one embodiment of the present disclosure. FIGS. 1A and 1B are schematic plan views of the display panel before a bending process is performed.

In some examples, as shown in FIGS. 1A and 1B, the display panel may include a display region AA and a peripheral region BB surrounding a periphery of the display region AA. For example, the peripheral region BB may include a first bezel region B1 located on a side of the display region AA, and bezel regions located on other sides of the display region AA (for example, which may include a second bezel region B2, a third bezel region B3, and a fourth bezel region B4). The first bezel region B1 may, for example, be a lower bezel of the display panel, the second bezel region B2 may, for example, be an upper bezel of the display panel, the third bezel region B3 may, for example, be a left bezel of the display panel, and the fourth bezel region B4 may, for example, be a right bezel of the display panel.

In some examples, as shown in FIGS. 1A and 1B, the display region AA may be a planar region including a plurality of sub-pixels PX forming a pixel array, and the plurality of sub-pixels PX may be configured to display a dynamic picture or a static image. The display region AA may be referred to as an active region (Active Area). In some examples, the display region AA may be rectangular. However, the present embodiment is not limited thereto. For example, the display region AA may be in other shapes, such as a circle or an oval. In some examples, the display panel may be a flexible panel, and accordingly the display panel may be deformable, for example, may be crimped, bent, folded, or curled.

In some examples, as shown in FIGS. 1A and 1B, the display region AA may at least include a plurality of sub-pixels PX, a plurality of gate lines GL, and a plurality of data lines DL. The plurality of gate lines GL may extend along a first direction X, and the plurality of data lines DL may extend along a second direction Y. Orthographic projections of the plurality of gate lines GL and the plurality of data lines DL on the base substrate may intersect to form a plurality of sub-pixel regions, and one sub-pixel PX may be disposed in each sub-pixel region. The plurality of data lines DL may be electrically connected to the plurality of sub-pixels PX and the plurality of data lines DL may be configured to provide data signals to the plurality of sub-pixels PX. The plurality of gate lines GL may be electrically connected to the plurality of sub-pixels PX and the plurality of gate lines GL may be configured to provide gate control signals to the plurality of sub-pixels PX. In some examples, the gate control signals may include a scan signal and a light emitting control signal, or may include a scan signal, or may include a scan signal, a reset control signal and a light emitting control signal.

In some examples, as shown in FIGS. 1A and 1B, the first direction X may be an extension direction (e.g., a row direction) of the gate lines GL in the display region AA, and the second direction Y may be an extension direction (e.g., a column direction) of the data lines DL in the display region AA. The first direction X and the second direction Y may intersect with each other, for example, the first direction X and the second direction Y may be perpendicular to each other.

In some examples, one pixel unit of the display region AA may include three sub-pixels which are a red sub-pixel, a green sub-pixel, and a blue sub-pixel respectively. However, the present embodiment is not limited thereto. In some examples, one pixel unit may include four sub-pixels, and the four sub-pixels are a red sub-pixel, a green sub-pixel, a blue sub-pixel, and a white sub-pixel respectively.

In some examples, a shape of a sub-pixel may be a rectangle, a rhombus, a pentagon, or a hexagon. When one pixel unit includes three sub-pixels, the three sub-pixels may be arranged side by side horizontally, side by side vertically, or arranged in a manner of a Chinese character " 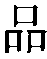 ". When one pixel unit includes four sub-pixels, the four sub-pixels may be arranged side by side horizontally, side by side vertically, or in a manner to form a square. However, the present embodiment is not limited thereto.

In some examples, one sub-pixel may include a pixel circuit and a light emitting element electrically connected to the pixel circuit. The pixel circuit may include multiple transistors and at least one capacitor. For example, the pixel circuit may have a 3T1C, 4T1C, 5T1C, 5T2C, 6T1C, 7T1C, or 8T1C structure. In the aforementioned circuit structures, T refers to a thin film transistor, C refers to a capacitor, a digit before T represents a quantity of thin film transistors in the circuit, and a digit before C represents a quantity of capacitors in the circuit. In some examples, the plurality of transistors in the pixel circuit may include a P-type transistor and an N-type transistor. However, the present embodiment is not limited thereto.

In some examples, the plurality of transistors in the pixel circuit may employ low temperature polysilicon thin film transistors and oxide thin film transistors. Low Temperature Polysilicon (LTPS) is adopted for an active layer of a low temperature polysilicon thin film transistor and an oxide semiconductor (Oxide) is adopted for an active layer of an oxide thin film transistor. The low temperature polysilicon thin film transistor has advantages such as a high migration rate and fast charging, and the oxide thin film transistor has advantages such as a low leakage current. The low temperature polysilicon thin film transistor and the oxide thin film transistor are integrated on one display panel, that is, an LTPS + Oxide (LTPO) display panel, so that advantages of both the low temperature polysilicon thin film transistor and the oxide thin film transistor may be utilized, low-frequency drive may be achieved, power consumption may be reduced, and display quality may be improved.

In some examples, the light emitting element may be any one of a Light Emitting Diode (LED), an Organic Light Emitting Diode (OLED), a Quantum Dot Light Emitting Diode (QLED), a micro LED (including: mini-LED or micro-LED), and the like. For example, the light emitting element may be an OLED, and the light emitting element may emit red light, green light, blue light, or white light, or the like under the driving of a pixel circuit corresponding to the light emitting element. A color of light emitted by the light emitting element may be determined as needed. In some examples, the light emitting element may include an anode, a cathode, and an organic light emitting layer located between the anode and the cathode. The anode of the light emitting element may be electrically connected to a corresponding pixel circuit. However, the present embodiment is not limited thereto.

In some examples, the display panel may be integrated with a touch structure. The display panel may include an organic light emitting diode (OLED) display substrate, or may be a plasma display device (PDP) display substrate, or may be an electrophoretic display (EPD) display substrate. For example, the display panel may include an OLED display substrate and a touch structure. The touch structure may be disposed on an encapsulation layer of the display substrate to form a structure of Touch on Thin Film Encapsulation (Touch on TFE). The display structure and touch structure are integrated together, which has advantages of being light and thin, and foldable or the like, and may meet requirements of products such as flexible folding and narrow bezels.

In some examples, the Touch on TFE structure mainly includes a Flexible Multi-Layer On Cell (FMLOC) structure and a Flexible Single-Layer On Cell (FSLOC) structure. The FMLOC structure is based on a working principle of mutual capacitance detection. Generally, a drive (Tx) electrode and a sensing (Rx) electrode are formed by two layers of metal, and an Integrated Circuit (IC) achieves a touch action by detecting mutual capacitance between the drive electrode and the sensing electrode. The FSLOC structure is based on a working principle of self-capacitance (or voltage) detection. Generally, a touch electrode is formed by using a single layer of metal, and an integrated circuit achieves a touch action by detecting a self-capacitance (or voltage) of the touch electrode.

FIG. 2 is a schematic partial cross-sectional view of a display region of a display panel according to at least one embodiment of the present disclosure. FIG. 2 is illustrated by taking a structure of one sub-pixel of the display region as an example. In this example, the transistor types of the plurality of transistors in the pixel circuit may be different, and may include, for example, low temperature polysilicon thin film transistors and oxide thin film transistors. The display panel of this example may be integrated with a touch structure, such as an integrated mutual capacitive touch structure, to form an FMLOC structure.

In some examples, as shown in FIG. 2, in a direction perpendicular to the display panel, the display region of the display panel may include a base substrate 10, and a circuit structure layer 12, a light emitting structure layer 13, an encapsulation structure layer 14, and a touch structure layer 50 that are sequentially arranged on the base substrate. The display structure layer may at least include the circuit structure layer 12 and the light emitting structure layer 13. The circuit structure layer 12 may at least include pixel circuits of a plurality of sub-pixels, and a pixel circuit of each sub-pixel may include a plurality of transistors and at least one capacitor. The light emitting structure layer 13 may at least include light emitting elements of a plurality of sub-pixels.

In some examples, FIG. 2 illustrates one first transistor 21, one second transistor 22, and one capacitor 23 included in each sub-pixel as an example. Transistor types of the first transistor 21 and the second transistor 22 may be different. For example, the first transistor 21 may be a low temperature polysilicon thin film transistor, and the second transistor 22 may be an oxide thin film transistor.

In some examples, the circuit structure layer 12 of the display region may include: a first semiconductor layer, a first gate metal layer, a second gate metal layer, a second semiconductor layer, a third gate metal layer, a first source-drain metal layer, and a second source-drain metal layer, which are disposed on the base substrate 10. A plurality of display region metal layers of the display structure layer of this example may include a first gate metal layer, a second gate metal layer, a third gate metal layer, a first source-drain metal layer, and a second source-drain metal layer. A first gate insulation (GI) layer 101 may be provided between the first semiconductor layer and the first gate metal layer, and a second gate insulation layer 102 may be provided between the first gate metal layer and the second gate metal layer. A first interlayer insulation (ILD) layer 103 and a first buffer layer 104 may be provided between the second gate metal layer and the second semiconductor layer, and the first buffer layer 104 may be located on a side of the first interlayer insulation layer 103 away from the base substrate 10. A third gate insulation layer 105 may be provided between the second semiconductor layer and the third gate metal layer. A second interlayer insulation layer 106 may be provided between the third gate metal layer and the first source-drain metal layer. A passivation (PVX) layer 107 and a first planarization (PLN) layer 108 may be provided between the first source-drain metal layer and the second source-drain metal layer, and the first planarization layer 108 may be located on a side of the passivation layer 107 away from the base substrate 10. A second planarization layer 109 may be provided on a side of the second source-drain metal layer away from the base substrate 10. The first gate insulation layer 101, the second gate insulation layer 102, the first interlayer insulation layer 103, the first buffer layer 104, the third gate insulation layer 105, the second interlayer insulation layer 106, and the passivation layer 107 may be inorganic insulation layers, and the first planarization layer 108 and the second planarization layer 109 may be organic insulation layers. However, the present embodiment is not limited thereto. In other examples, a second buffer layer may also be provided on a side of the first semiconductor layer close to the base substrate, and the second buffer layer may prevent harmful substances in the base substrate from intruding into interior of the display panel, and may also increase adhesion of a film layer in the display panel on the base substrate. In other examples, a bottom shielding metal (BSM) layer may also be provided on a side of the second buffer layer close to the base substrate, and the bottom shielding metal layer may be configured to at least partially cover active layers of the transistors of the pixel circuits to avoid the influence of external light on the performance of the transistors. In other examples, the passivation layer may be omitted between the first source-drain metal layer and the second source-drain metal layer, and only the first planarization layer may be provided between the first source-drain metal layer and the second source-drain metal layer. In other examples, the first buffer layer may be omitted between the second gate metal layer and the second semiconductor layer, and only the first interlayer insulation layer 103 may be provided.

In some examples, as shown in FIG. 2, the first semiconductor layer of the display region may at least include a first active layer 210 of the first transistor 21. The first active layer 210 of the first transistor 21 may include a first region 2101, a second region 2102, and a channel region 2100 located between the first region 2101 and the second region 2102. The first gate metal layer may at least include a first gate 213 of the first transistor 21, and a first plate 231 of the capacitor 23. An orthographic projection of the first gate 213 of the first transistor 21 on the base substrate 10 may cover an orthographic projection of the channel region 2100 of the first active layer 210 on the base substrate 10. The second gate metal layer may at least include a second plate 232 of the capacitor 23 and a third gate 224 of the second transistor 22. Orthographic projections of the second plate 232 and the first plate 231 of the capacitor 23 on the base substrate 10 may at least partially overlap, for example, the orthographic projections of the second plate 232 and the first plate 231 of the capacitor 23 on the base substrate 10 may coincide. The second semiconductor layer may at least include a second active layer 220 of the second transistor 22. The third gate metal layer may at least include a second gate 223 of the second transistor 22. An orthographic projection of the second gate 223 of the second transistor 22 on the base substrate 10 may partially overlap with an orthographic projection of the second active layer 220 on the base substrate 10. An orthographic projection of the third gate 224 of the second transistor 22 on the base substrate 10 may partially overlap with an orthographic projection of the second active layer 220 on the base substrate 10. The third gate 224 may be a bottom gate of the second transistor 22, and the second gate 223 may be a top gate of the second transistor 22.

In some examples, as shown in FIG. 2, the first source-drain metal layer may at least include a first source 211 and a first drain 212 of the first transistor 21, and a second source 221 and a second drain 222 of the second transistor 22. The second interlayer insulation layer 106 may be provided with a plurality of pixel vias (including, for example, a first pixel via, a second pixel via, a third pixel via, and a fourth pixel via) in the display region, and the second interlayer insulation layer 106, the third gate insulation layer 105, the first buffer layer 104, the first interlayer insulation layer 103, the second gate insulation layer 102, and the first gate insulation layer 101 in the first pixel via may be removed to expose at least part of a surface of a first region 2101 of the first active layer 210. The second interlayer insulation layer 106, the third gate insulation layer 105, the first buffer layer 104, the first interlayer insulation layer 103, the second gate insulation layer 102, and the first gate insulation layer 101 in the second pixel via may be removed to expose at least part of a surface of a second region 2102 of the first active layer 210. The second interlayer insulation layer 106 and the third gate insulation layer 105 in the third pixel via and the fourth pixel via may be removed to expose at least portions of surfaces of both ends of the second active layer 220. The first source 211 of the first transistor 21 may be electrically connected to the first region 2101 of the first active layer 210 through the first pixel via, and the first drain 212 may be electrically connected to the second region 2102 of the first active layer 210 through the second pixel via. The second source 221 of the second transistor 22 may be electrically connected to one end of the second active layer 220 through the third pixel via, and the second drain 222 of the second transistor 22 may be electrically connected to the other end of the second active layer 220 through the fourth pixel via. The second source-drain metal layer may at least include a first transfer electrode 241. The first transfer electrode 241 may be electrically connected to the first drain 212 of the first transistor 21 of the pixel circuit through a fifth pixel via provided in the passivation layer 107 and the first planarization layer 108. In this example, an electrical connection between the pixel circuit and the light emitting element may be achieved through the first transfer electrode 241.

In some examples, a gate line of the display region may be located, for example, in the first gate metal layer and the third gate metal layer, a data line of the display region may be located, for example, in the second source-drain metal layer, and a high-potential power supply line of the display region may be located, for example, in the second source-drain metal layer. The present embodiment is not limited thereto.

In some examples, as shown in FIG. 2, the light emitting structure layer 13 may include a pixel definition layer 134 and a plurality of light emitting elements. For example, each light emitting element may include a first electrode 131, an organic light emitting layer 132, and a second electrode 133 which are stacked. The first electrode 131 of the light emitting element may be an anode, and the first electrode 131 may be provided on the second planarization layer 109 and electrically connected to the first transfer electrode 241 through a six pixel via provided in the second planarization layer 109. The pixel definition layer 134 is provided on the first electrode 131 and the second planarization layer 109, and may be provided with a plurality of pixel openings, and one pixel opening may expose at least portion of a surface of a corresponding first electrode 131. At least a portion of the organic light emitting layer 132 may be disposed within one pixel opening and connected to a corresponding first electrode 131. The second electrode 133 may be disposed on the organic light emitting layer 132 and be connected to the organic light emitting layer 132. The organic light emitting layer 132 may emit light of a corresponding color under the driving of the first electrode 131 and the second electrode 133.

In some examples, the organic light emitting layer 132 of the light emitting element may include a light emitting layer (EML), and include one or more film layers of a hole injection layer (HIL), a hole transport layer (HTL), a hole block layer (HBL), an electron block layer (EBL), an electron injection layer (EIL), and an electron transport layer (ETL). Under the driving of voltages of the first electrode 131 and the second electrode 133, light may be emitted at a required gray scale using light emitting characteristics of an organic material.

In some examples, light emitting layers of light emitting elements in different colors may be different. For example, a red light emitting element includes a red light emitting layer, a green light emitting element includes a green light emitting layer, and a blue light emitting element includes a blue light emitting layer. In order to reduce a process difficulty and improve a yield, a common layer may be adopted for a hole injection layer and a hole transport layer located on one side of a light emitting layer, and a common layer may be adopted for an electron injection layer and an electron transport layer located on the other side of the light emitting layer. In some examples, any one or more layers of the hole injection layer, the hole transport layer, the electron injection layer, and the electron transport layer may be made through one process (one evaporation process or one inkjet printing process), and isolation may be achieved by means of a formed film layer surface height difference or by means of a surface treatment or the like. For example, any one or more of hole injection layers, hole transport layers, electron injection layers, and electron transport layers corresponding to adjacent sub-pixels may be isolated. In some examples, the organic light emitting layer may be prepared and formed through evaporation using a fine metal mask (FMM) or an open mask, or prepared and formed using an inkjet process.

In some examples, as shown in FIG. 2, the encapsulation structure layer 14 may include a first encapsulation layer 141, a second encapsulation layer 142, and a third encapsulation layer 143 which are stacked. Herein, the first encapsulation layer 141 and the third encapsulation layer 143 may be of inorganic materials such as silicon nitride, silicon oxide, silicon oxynitride, or the like, which have high density and may prevent intrusion of water, oxygen, or the like. The second encapsulation layer 142 may be disposed between the first encapsulation layer 141 and the third encapsulation layer 143 to ensure that external water vapor cannot enter a light emitting element. The second encapsulation layer 142 may be of an organic material, which may be for example, a polymer material containing a desiccant or a polymer material capable of blocking water vapor, or a polymer resin or the like to flatten the surface of the display panel and relieve the stress of the first encapsulation layer 141 and the third encapsulation layer 143. The second encapsulation layer 142 may further include a water-absorbing material such as a desiccant to absorb substances such as water and oxygen entering the interior. However, the present embodiment is not limited thereto. For example, an encapsulation structure layer may be of a five-layer stacked structure of inorganic/organic/inorganic/organic/inorganic.

In some examples, the touch structure layer of the display region may include: a plurality of first touch electrodes, a plurality of first connection portions, a plurality of second touch electrodes, and a plurality of second connection portions. The plurality of first touch electrodes may be disposed in a same layer, and adjacent first touch electrodes may be connected through a first connection portion. The plurality of second touch electrodes may be disposed in a same layer, and adjacent second touch electrodes may be connected through a second connection portion.

In some examples, as shown in FIG. 2, in a direction perpendicular to the display panel, the touch structure layer 15 of the display region may include a touch buffer layer (TBL) 150, a first touch conductive layer 151, a touch interlayer insulation layer (TLD) 153, a second touch conductive layer 152, and a protection layer 154 sequentially arranged. Herein, the touch buffer layer 150 and the touch interlayer insulation layer 153 may be inorganic insulation layers, and the protection layer 154 may be an organic insulation layer. For example, the first touch conductive layer 151 may include a plurality of first touch electrodes, a plurality of second touch electrodes, and a plurality of first connection portions. A first touch electrode and a first connection portion may be of an interconnected integral structure. The second touch conductive layer 152 may include a plurality of second connection portions. A second connection portion may be connected to an adjacent second touch electrode through a via formed in the touch interlayer insulation layer. However, the present embodiment is not limited thereto. In other examples, the first touch conductive layer may include: a plurality of first touch electrodes, a plurality of second touch electrodes, and a plurality of second connection portions, and a second touch electrode and a second connection portion may be of an interconnected integral structure. The second touch conductive layer may include a plurality of first connection portions, and a first connection portion may be interconnected to an adjacent first touch electrode through a via formed in the touch interlayer insulation layer. In some examples, the first touch electrodes may be drive (Tx) electrodes and the second touch electrodes may be sensing (Rx) electrodes. Alternatively, the first touch electrodes may be sensing (Rx) electrodes and the second touch electrodes may be drive (Tx) electrodes. The present embodiment is not limited thereto.

In some examples, the first touch electrode and the second touch electrode may have a rhombus shape, such as a regular rhombus, a horizontally longer rhombus, or a vertically longer rhombus. In other examples, the first touch electrode and the second touch electrode may have any one or more of shapes of a triangle, a square, a trapezoid, a parallelogram, a pentagon, a hexagon, and another polygon, which is not limited in the embodiments of the present disclosure.

In some examples, the first touch electrode and the second touch electrode may be in a form of transparent conductive electrodes. In some other examples, the first touch electrode and the second touch electrode may be in a form of a metal grid. The metal grid may be formed by a plurality of interweaved metal lines, and may include a plurality of grid patterns. The grid patterns may be polygons formed by a plurality of metal lines. The first touch electrodes and the second touch electrodes in the form of the metal grid have advantages of small resistance, small thickness, fast response speed, and the like.

In some examples, as shown in FIG. 1A, the first bezel region B1 of the display panel may include a fan-out trace region B11 and a signal access region B12 arranged sequentially in a direction away from the display region AA. Only a number of traces within the first bezel region are shown in FIG. 1A for illustrative purposes. The quantity of traces in the first bezel region is not limited in this example.

In some examples, as shown in FIG. 1A, the fan-out trace region B11 may be connected between the display region AA and the signal access region B12. The fan-out trace region B11 may be provided with at least a plurality of data fan-out lines 42. The plurality of data fan-out lines 42 may be electrically connected to the plurality of data lines DL in the display region AA, for example, the plurality of data fan-out lines 42 and the plurality of data lines DL may be electrically connected in one-to-one correspondence. The plurality of data fan-out lines 42 may extend to the signal access region B12 in a fan-out trace manner. The plurality of data fan-out lines 42 and the plurality of data lines DL may be located in different film layers, and the data fan-out lines 42 may be connected to the data lines DL through vias formed in the insulation layer.

In some examples, as shown in FIG. 1A, the signal access region B12 may include at least one first signal access region B121. In this example, one first signal access region is illustrated and described as an example. In other examples, the display panel is a large-size panel, the display panel may include a plurality of first signal access regions, and the plurality of first signal access regions may be sequentially arranged along the first direction X.

In some examples, as shown in FIG. 1A, the first signal access region B121 may also be referred to as a drive chip (IC) setup region. The first signal access region B121 may be provided with a plurality of contact pads (bumps) 31, which may be configured to be bonded to at least one drive chip. The drive chip may be configured to generate a drive signal required for driving sub-pixels and to supply the drive signal to the data lines DL of the display region AA. For example, the drive signal may be a data signal that drives the sub-pixels. In some examples, the drive chip may be a central processing unit, a digital signal processor, a system-on-chip (SoC), or the like. For example, the drive chip may also include hardware circuits, computer executable codes and the like. The hardware circuits may include conventional very large scale integration (VLSI) circuits or gate arrays as well as existing semiconductors such as logic chips, transistors or other discrete components; and the hardware circuits may also include field programmable gate arrays, programmable array logic, programmable logic devices, and the like.

In some examples, as shown in FIG. 1A, the signal access region B12 may be provided with at least a plurality of data leads 41, and the plurality of data leads 41 may be electrically connected to the plurality of data fan-out lines 42 of the fan-out trace region B11, for example, in a one-to-one correspondence. For example, the data lead 41 and the data fan-out line 42 connected thereto may be of an integral structure connected to each other. The plurality of data leads 41 may extend into the first signal access region B121, and may be electrically connected to the plurality of contact pads 31 in the first signal access region B121. For example, the plurality of data leads 41 and the plurality of contact pads 31 may be electrically connected in one-to-one correspondence, or one data lead 41 may be electrically connected to at least one contact pad 31. The data lead 41 and the data fan-out line 42 may transmit a data signal supplied from the drive chip to the data line DL of the display region.

In some examples, as shown in FIG. 1A, the plurality of contact pads 31 of the first signal access region B121 may be arranged in a plurality of rows (e.g., two rows or three rows). The plurality of contact pads 31 included in each row may be sequentially arranged along the first direction X, and the plurality of rows of contact pads 31 may be sequentially arranged along the second direction Y. Two adjacent rows of contact pads 31 may be staggered in the first direction X. However, the present embodiment is not limited thereto. In other examples, the plurality of contact pads of the first signal access region B121 may be arranged in one row. In this example, one row of contact pads may also be referred to as a group of contact pads.

In some examples, as shown in FIG. 1B, the first bezel region B1 of the display panel may include a fan-out trace region B11, a bending region B13, and a signal access region B12 arranged sequentially in a direction away from the display region AA. Only a number of traces within the first bezel region are shown in FIG. 1B for illustrative purposes. The quantity of traces in the first bezel region is not limited in this embodiment.

In some examples, as shown in FIG. 1B, the bending region B13 is connected between the fan-out trace region B11 and the signal access region B12, and may be configured such that the signal access region B12 is bent to the back of the display region AA. At least a plurality of data bending connection lines 43 may be provided in the bending region B13. One end of the data bending connection line 43 may be connected to the data fan-out line 42 in the fan-out trace region B11, and the other end of the data bending connection line 43 may be connected to the data lead 41 in the signal access region B12. The plurality of data bending connection lines 43 may be structures arranged in a same layer, for example, located in the first source-drain metal layer or the second source-drain metal layer. The rest of the structure of the first bezel region B1 of this example can refer to the description of the aforementioned embodiment, and thus the description thereof will not be repeated here.

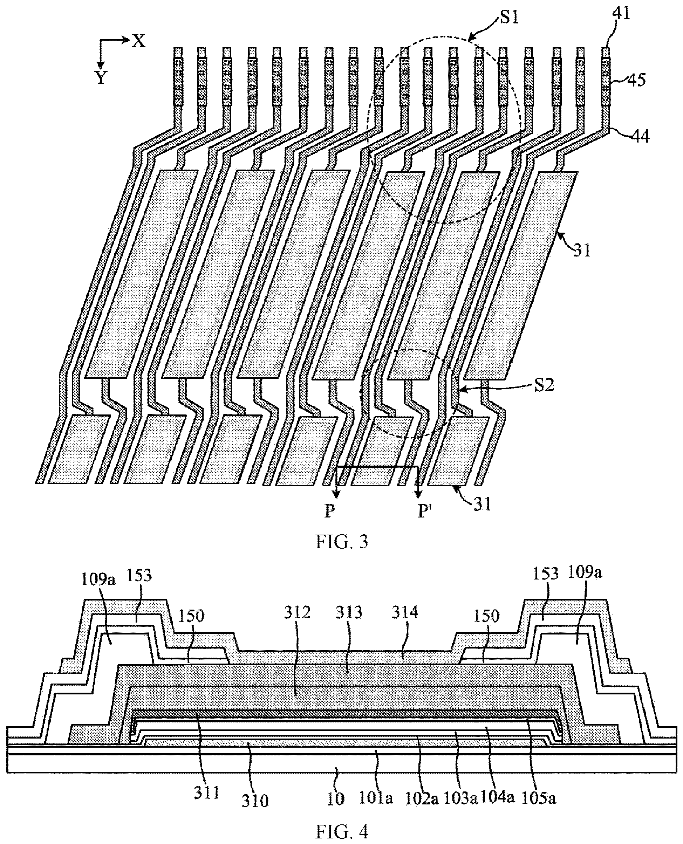

FIG. 3 is a schematic partial view of a signal access region according to at least one embodiment of the present disclosure. In some examples, the plurality of contact pads 31 of the first signal access region may be divided into at least a plurality of groups (e.g., three groups). In FIG. 3, two groups of contact pads (e.g., a first group of contact pads and a second group of contact pads) are exemplified for illustration and description. The second group of contact pads may be located on a side of the first group of contact pads away from the display region. The first group of contact pads may include a plurality of contact pads 31 arranged along the first direction X. The second group of contact pads may include a plurality of contact pads 31 arranged along the first direction X. The first group of contact pads and the second group of contact pads may be staggered in the first direction X. For example, the contact pads within the first group of contact pads and the second group of contact pads may not be aligned in the second direction Y. There is a spacing between adjacent contact pads within the same group, and there is a spacing between contact pads of adjacent groups. The group of contact pads of this example may be a row of contact pads. The number of rows of contact pads and the number of contact pads per row are not limited in this example.

In some examples, as shown in FIG. 3, the plurality of data leads 41 may extend substantially along the second direction Y in the spacing between the plurality of contact pads 31. For example, two data leads 41 may be provided between two adjacent contact pads 31 of one group of contact pads. One data lead 41 may be electrically connected to at least one contact pad 31, for example, one data lead 41 may be connected to one contact pad 31.

FIG. 4 is an example of a partial cross-sectional view taken along a direction P-P' in FIG. 3. FIG. 4 is illustrated by taking a cross-sectional structure of one contact pad 31 as an example. In some examples, as shown in FIGS. 3 and 4, one contact pad 31 may include four contact pad metal layers that are stacked, including, for example, a first contact pad metal layer 311, a second contact pad metal layer 312, a third contact pad metal layer 313, and a fourth contact pad metal layer 314. The first contact pad metal layer 311, the second contact pad metal layer 312, the third contact pad metal layer 313, and the fourth contact pad metal layer 314 may be sequentially arranged along a direction away from the base substrate 10. The first contact pad metal layer 311 may be in direct contact with the second contact pad metal layer 312, the third contact pad metal layer 313 may be in direct contact with the second contact pad metal layer 312, and the fourth contact pad metal layer 314 may be in contact with the third contact pad metal layer 313 through vias formed in the first organic insulation layer 109a, the touch buffer layer 150, and the touch interlayer insulation layer 153.

In some examples, as shown in FIG. 4, an orthographic projection of the second contact pad metal layer 312 on the base substrate 10 may cover an orthographic projection of the first contact pad metal layer 311 on the base substrate 10. The second contact pad metal layer 312 may cover an edge of the first contact pad metal layer 311. An orthographic projection of the third contact pad metal layer 313 on the base substrate 10 may cover an orthographic projection of the second contact pad metal layer 312 on the base substrate 10. The third contact pad metal layer 313 may cover an edge of the second contact pad metal layer 312. An orthographic projection of the fourth contact pad metal layer 314 on the base substrate 10 may cover an orthographic projection of the third contact pad metal layer 313 on the base substrate 10. The fourth contact pad metal layer 314 may be in contact with a portion of a surface of the third contact pad metal layer 313 away from the base substrate 10. In this example, the third contact pad metal layer 313 covers the edge of the second contact pad metal layer 312, and the second contact pad metal layer 312 covers the edge of the first contact pad metal layer 311, thereby maintaining structural stability of the contact pad.

In some examples, as shown in FIG. 4, the first contact pad metal layer 311 may be located in the third gate metal layer, and the first contact pad metal layer 311 and the second gate of the second transistor of the display region may be structures arranged in a same layer. The second contact pad metal layer 312 may be located in the first source-drain metal layer, and the second contact pad metal layer 312 and the first source and the first drain of the first transistor and the second source and the second drain of the second transistor of the display region may be structures arranged in a same layer. The third contact pad metal layer 313 may be located in the second source-drain metal layer, and the third contact pad metal layer 313 and the first transfer electrode of the display region may be structures arranged in a same layer. The fourth contact pad metal layer 314 may be located in the second touch conductive layer, and the fourth contact pad metal layer 314 and the second connection portion of the touch structure layer of the display region may be structures arranged in a same layer, for example. However, the present embodiment is not limited thereto. In other examples, the fourth contact pad metal layer may be located in the first touch conductive layer. In other examples, when the touch structure layer includes only one touch conductive layer, the fourth contact pad metal layer may be arranged in the same layer as the touch conductive layer.

In some examples, as shown in FIGS. 3 and 4, the contact pad 31 may further include an inactive contact pad metal layer 310 located on a side of the plurality of contact pad metal layers close to the base substrate 10. The inactive contact pad metal layer 310 may be located on a side of the first contact pad metal layer 311 close to the base substrate 10. An orthographic projection of the first contact pad metal layer 311 on the base substrate 10 may cover an orthographic projection of the inactive contact pad metal layer 310 on the base substrate 10. The first contact pad metal layer 311 and the inactive contact pad metal layer 310 are not directly electrically connected. In this example, by providing the inactive contact pad metal layer 310, a plurality of contact pad metal layers can be raised, thereby reducing the height difference between the contact pad and the peripheral film layer, and alleviating the crack of the film layer existing in the bonding process of the drive chip.

In some examples, as shown in FIG. 4, a first inorganic insulation layer 101a may be provided on a side of the inactive contact pad metal layer 310 close to the base substrate 10. For example, the first inorganic insulation layer 101a may be arranged in the same layer as the first gate insulation layer of the display region. A second inorganic insulation layer 102a, a third inorganic insulation layer 103a, a fourth inorganic insulation layer 104a, and a fifth inorganic insulation layer 105a may be provided between the first contact pad metal layer 311 and the inactive contact pad metal layer 310 of the contact pads. The second inorganic insulation layer 102a, the third inorganic insulation layer 103a, the fourth inorganic insulation layer 104a, and the fifth inorganic insulation layer 105a may be sequentially arranged in a direction away from the base substrate 10. For example, the second inorganic insulation layer 102a may be arranged in the same layer as the second gate insulation layer of the display region, the third inorganic insulation layer 103a may be arranged in the same layer as the first interlayer insulation layer of the display region, the fourth inorganic insulation layer 104a may be arranged in the same layer as the first buffer layer of the display region, and the fifth inorganic insulation layer 105a may be arranged in the same layer as the third gate insulation layer of the display region.

In some examples, as shown in FIG. 4, orthographic projections of the first inorganic insulation layer 101a and the second inorganic insulation layer 102a on the base substrate 10 may cover orthographic projections of the contact pads on the base substrate 10, and may also be disposed in the spacing between adjacent contact pads. The inorganic composite insulation layer of this example may include a third inorganic insulation layer 103a, a fourth inorganic insulation layer 104a, and a fifth inorganic insulation layer 105a. The inorganic composite insulation layer is located on a side of the first contact pad metal layer 311 close to the base substrate 10, and is located between the first contact pad metal layer 311 and the inactive contact pad metal layer 310. An orthographic projection of the inorganic composite insulation layer on the base substrate 10 may cover the orthographic projection of the inactive contact pad metal layer 310 on the base substrate 10. The orthographic projection of the inorganic composite insulation layer on the base substrate 10 may cover orthographic projections of overlapping regions of the first contact pad metal layer 311, the second contact pad metal layer 312, the third contact pad metal layer 313, and the fourth contact pad metal layer 314 on the base substrate 10. A side edge of the inorganic composite insulation layer is in contact with the second contact pad metal layer 312. The inorganic composite insulation layer of this example is disposed below the four contact pad metal layers, so that the four contact pad metal layers can be raised, thereby reducing the height difference between the contact pad and the peripheral film layer, and alleviating the crack of the film layer existing in the bonding process of the drive chip.

In some examples, as shown in FIG. 4, a first organic insulation layer 109a may be provided on a side of the third contact pad metal layer 313 away from the base substrate 10. The first organic insulation layer 109a may be arranged in the same layer as the second planarization layer 109 of the display region, for example. An orthographic projection of the first organic insulation layer 109a on the base substrate 10 may partially overlap with the orthographic projection of the third contact pad metal layer 313 on the base substrate 10. For example, the first organic insulation layer 109a may cover an edge of the third contact pad metal layer 313. The first organic insulation layer 109a may not be disposed in a gap between adjacent contact pads. A touch buffer layer 150 and a touch interlayer insulation layer 153 may be sequentially provided on a side of the first organic insulation layer 109a away from the base substrate 10. Orthographic projections of the touch buffer layer 150 and the touch interlayer insulation layer 153 on the base substrate 10 may cover the orthographic projection of the first organic insulation layer 109a on the base substrate 10. The fourth contact pad metal layer 314 may be electrically connected to the third contact pad metal layer 313 through vias formed in the touch interlayer insulation layer 153, the touch buffer layer 150, and the first organic insulation layer 109a.

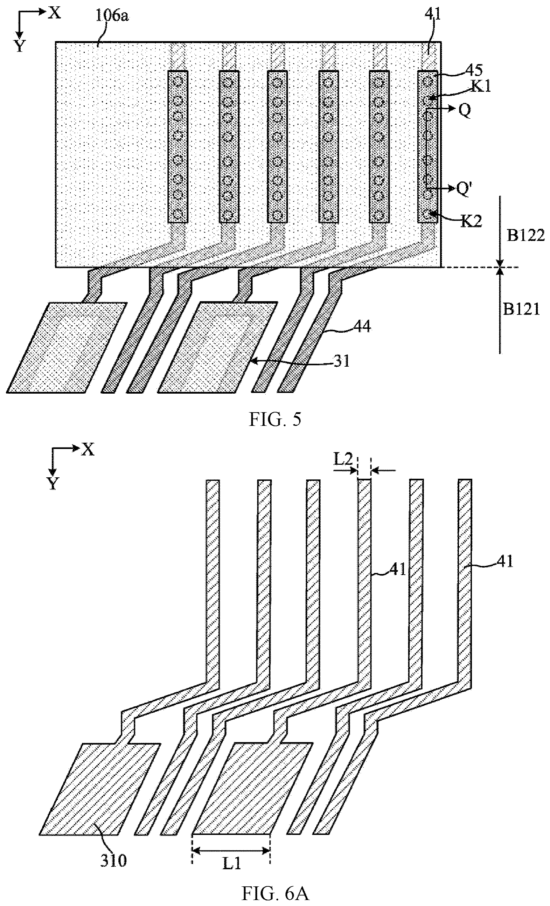

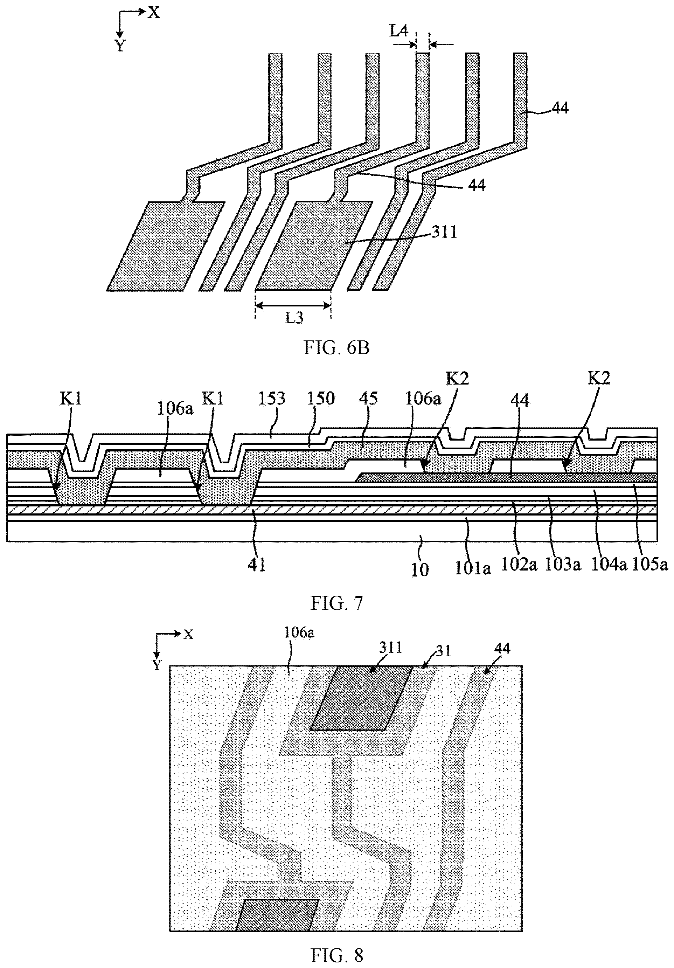

FIG. 5 is a partially enlarged schematic view of a region S1 in FIG. 3. FIG. 6A is a schematic view of a first gate metal layer in FIG. 5. FIG. 6B is a schematic view of a third gate metal layer in FIG. 5. FIG. 7 is a schematic partial cross-sectional view taken along a direction Q-Q' in FIG. 5.

In some examples, as shown in FIGS. 3 and 5, the signal access region may also be provided with a plurality of access connection lines 44. The plurality of access connection lines 44 may extend to the first signal access region B121 in substantially the second direction Y, and may be connected to the contact pads in the first signal access region B121. The plurality of data leads 41 may extend to the first signal access region B121 in substantially the second direction Y. The plurality of access connection lines 44 may be electrically connected to the plurality of data leads 41, for example, the plurality of access connection lines 44 and the plurality of data leads 41 may be electrically connected in one-to-one correspondence. An orthographic projection of the access connection line 44 on the base substrate and an orthographic projection of the data lead 41 connected thereto on the base substrate may at least partially overlap, for example, an orthographic projection of the access connection line 44 on the base substrate may be located within a range of an orthographic projection of the corresponding data lead 41 on the base substrate. The access connection line 44 and the data lead 41 may be electrically connected through the connection electrode 45. The plurality of connection electrodes 45 may be located on a side of the plurality of contact pads 31 close to the display region. For example, the plurality of connection electrodes 45 may be located on a side of the first group of contact pads away from the second group of contact pads (i.e., a side close to the display region), and the plurality of connection electrodes 45 may be arranged in a row along the first direction X. However, the present embodiment is not limited thereto. In other examples, the plurality of connection electrodes may be arranged in a plurality of rows.

In some examples, as shown in FIGS. 5 and 6A, the plurality of data leads 41 may be located in the first gate metal layer. The plurality of data leads 41 may extend substantially along the second direction Y and are arranged sequentially along the first direction X. One data lead 41 and the inactive contact pad metal layer 310 of at least one contact pad may be of an integral structure connected to each other. A length L1 of the inactive contact pad metal layer 310 along the first direction X may be greater than a line width L2 of the data lead 41 (i.e., the length along the first direction X). Two data leads 41 may be provided between two adjacent inactive contact pad metal layers 310. However, the present embodiment is not limited thereto. For example, one or three or more data leads may be provided between two adjacent inactive contact pad metal layers.

In some examples, as shown in FIGS. 5 and 6B, the plurality of access connection lines 44 may be located in the third gate metal layer. The plurality of access connection lines 44 may extend substantially along the second direction Y and be sequentially arranged along the first direction X. One access connection line 44 may be electrically connected to at least one contact pad. The access connection line 44 and the first contact pad metal layer 311 of the contact pad connected thereto may be of an integral structure connected to each other. A length L3 of the first contact pad metal layer 311 along the first direction X may be greater than a line width L4 of the access connection line 44 (i.e., the length along the first direction X). Two access connection lines 44 may be provided between two adjacent first contact pad metal layers 311. However, the present embodiment is not limited thereto. For example, one or three or more data leads may be provided between two adjacent first contact pad metal layers.

In some examples, as shown in FIGS. 5 and 7, one access connection line 44 may be electrically connected to one data lead 41 through one connection electrode 45. The connection electrode 45 may be located on a side of the access connection line 44 and the data lead 41 away from the base substrate 10. For example, the connection electrode 45 may be located in the first source-drain metal layer. The data lead 41 may be located on the first gate metal layer, and a first inorganic insulation layer 101a arranged in the same layer as the first gate insulation layer may be provided on a side of the data lead 41 close to the base substrate 10. The access connection line 44 may be located in the third gate metal layer. A second inorganic insulation layer 102a arranged in the same layer as the second gate insulation layer, a third inorganic insulation layer 103a arranged in the same layer as the first interlayer insulation layer, a fourth inorganic insulation layer 104a arranged in the same layer as the first buffer layer, and a fifth inorganic insulation layer 105a arranged in the same layer as the third gate insulation layer may be sequentially arranged between the data lead 41 and the access connection line 44. A sixth inorganic insulation layer 106a may be provided between the access connection line 44 and the connection electrode 45. For example, the sixth inorganic insulation layer 106a may be arranged in the same layer as the second interlayer insulation layer of the display region.

In some examples, as shown in FIGS. 5 and 7, the sixth inorganic insulation layer 106a of the signal access region may be provided with a plurality of first vias K1 and a plurality of second vias K2. The sixth inorganic insulation layer 106a, the fifth inorganic insulation layer 105a, the fourth inorganic insulation layer 104a, the third inorganic insulation layer 103a, and the second inorganic insulation layer 102a in the first via K1 may be removed to expose a part of a surface of the data lead 41. The sixth inorganic insulation layer 106a in the second via K2 may be removed to expose a part of a surface of the access connection line 44.

In some examples, as shown in FIGS. 5 and 7, the connection electrode 45 may be a strip-shaped structure extending along the second direction Y. One end of the connection electrode 45 may be electrically connected to the data lead 41 through the plurality of first vias K1 (for example, four first vias K1 arranged along the second direction Y), and the other end of the connection electrode 45 may be electrically connected to the access connection line 44 through the plurality of second vias K2 (for example, four second vias K2 arranged along the second direction Y). In this example, the electrical connection between the data lead 41 and the access connection line 44 is achieved by the connection electrode 45. There is no direct electrical connection between the data lead 41 and the access connection line 44 disposed in the spacing between adjacent contact pads, but the orthographic projections of the data lead 41 and the access connection line 44 disposed in the spacing between adjacent contact pads on the base substrate overlap. The fifth inorganic insulation layer 105a, the fourth inorganic insulation layer 104a, the third inorganic insulation layer 103a, and the second inorganic insulation layer 102a may be provided between the data lead 41 and the access connection line 44 disposed in the spacing between adjacent contact pads. In this example, a part of the inorganic composite insulation layer (including the fifth inorganic insulation layer 105a, the fourth inorganic insulation layer 104a, and the third inorganic insulation layer 103a) is located in the spacing between adjacent contact pads. The orthographic projection of the inorganic composite insulation layer in the spacing between adjacent contact pads on the base substrate may overlap with the orthographic projections of the data lead 41 and the access connection line 44 on the base substrate, for example, may cover the orthographic projection of the data lead 41 on the base substrate. The inorganic composite insulation layer in the spacing between the data leads 41 and the adjacent contact pads, in the spacing between the adjacent data leads 41 may be removed. However, the present embodiment is not limited thereto. In this example, by removing the inorganic composite insulation layer in the spacing between adjacent contact pads except where the data lead and the access connection line are located, the height of the film layer at the periphery of the contact pad can be reduced, thereby reducing the height difference between the contact pad and the peripheral film layer, and alleviating the crack of the film layer existing in the bonding process of the drive chip.

In some examples, as shown in FIG. 5, an orthographic projection of the sixth inorganic insulation layer 106a of the signal access region on the base substrate may partially overlap with the orthographic projections of the plurality of data leads 41 and the plurality of access connection lines 44 on the base substrate, and the orthographic projection of the sixth inorganic insulation layer 106a on the base substrate may not overlap with the orthographic projection of the plurality of contact pads 31 on the base substrate. The orthographic projection of the sixth inorganic insulation layer 106a on the base substrate may not overlap with the orthographic projections of the data lead 41 and the access connection line 44 in the spacing between the plurality of contact pads 31 on the base substrate. For example, the signal access region may include a first signal access region B121 and a second region B122 located on a side of the first signal access region B121 close to the display region. The plurality of contact pads 31 may be located in the first signal access region B121, and the plurality of connection electrodes 45 may be located in the second region B122. The sixth inorganic insulation layer 106a in the first signal access region B121 may be removed, and the sixth inorganic insulation layer 106 in the second region B122 may be retained. In this example, the sixth inorganic insulation layer is not provided in the first signal access region B121 (including the position where the contact pad is located and the spacing region between the contact pads), and the height difference between the contact pad and the peripheral film layer can be improved. Furthermore, it is possible to avoid the risk of circuit breaking caused by metal overetching due to the etching process for the sixth inorganic insulation layer in the first signal access region B121.

Hereinafter, an exemplary description will be given through a preparation process of a display panel with reference to FIG. 2 to FIG. 7. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

In the present disclosure, "A and B are structures arranged in a same layer" or " A and B are arranged in a same layer" means that A and B are simultaneously formed by a same patterning process, a "thickness" of the film layer is a dimension of the film layer in a direction perpendicular to the display panel, and a "height" of the film layer is a distance between a surface of the film layer away from the base substrate and a plane on which the base substrate is located. In exemplary embodiments of the present disclosure, "an orthographic projection of A includes an orthographic projection of B" or "an orthographic projection of B is located within a range of an orthographic projection of A" means that a boundary of the orthographic projection of B falls within a range of a boundary of the orthographic projection of A, or a boundary of the orthographic projection of A overlaps with a boundary of the orthographic projection of B.

In some examples, a preparation process of a display panel may include following operations.
(1) Providing a base substrate. In some examples, the base substrate 10 may be a flexible substrate, including, for example, a first flexible material layer, a first inorganic material layer, a second flexible material layer, and a second inorganic material layer which are stacked on a glass carrier plate. The first and second flexible material layers may be made of materials such as polyimide (PI), polyethylene terephthalate (PET), or a surface-treated polymer soft film. The first inorganic material layer and the second inorganic material layer may be made of Silicon Nitride (SiNx) or Silicon Oxide (SiOx), etc., which are used for improving water and oxygen resistance of the base substrate. The first inorganic material layer and the second inorganic material layer may be also referred to as barrier layers. However, the present embodiment is not limited thereto.
   In some examples, taking a stacked structure of a first flexible material layer/a first barrier layer/a second barrier layer/a second flexible material layer as an example, its preparation process includes: firstly, coating a layer of polyimide on a glass carrier plate, and curing it into a film to form a first flexible material layer; then, depositing a layer of barrier thin film on the first flexible material layer to form a first barrier layer covering the first flexible layer; then coating a layer of polyimide on the first barrier layer again, and curing it into a film to form a second flexible material layer; and then depositing a layer of barrier thin film on the second flexible material layer to form a second barrier layer covering the second flexible material layer, thereby completing preparation of the flexible base substrate 10.
(2) Preparing a first semiconductor layer on the base substrate. In some examples, a first semiconductor thin film is deposited on the base substrate, and the first semiconductor thin film is patterned by a patterning process to form a first semiconductor layer. As shown in FIG. 2, the first semiconductor layer may be formed in the display region, including at least the first active layer 210 of the first transistor 21.
(3) Preparing a first gate metal layer on the base substrate. In some examples, a first insulation thin film and a first conductive thin film are deposited sequentially on the base substrate on which the aforementioned structure is formed, and the first conductive thin film is patterned by a patterning process to form a first gate metal layer disposed on the first insulation thin film. The first insulation thin film may form the first gate insulation layer 101 in the display region and the first inorganic insulation layer 101a in the signal access region. As shown in FIGS. 2, 4, and 7, the first gate metal layer may at least include the first gate 213 of the first transistor 21 located in the display region, the first plate 231 of the capacitor 23, and the data lead 41 and the inactive contact pad metal layer 310 located in the signal access region. One data lead 41 and at least one inactive contact pad metal layer 310 may be of an integral structure connected to each other.
(4) Preparing a second gate metal layer on the base substrate. In some examples, a second insulation thin film is deposited on the base substrate on which the aforementioned structure is formed, so as to form a second gate insulation layer 102 located in the display region and a second inorganic insulation layer 102a located in the signal access region. Subsequently, a second conductive thin film is deposited, and the second conductive thin film is patterned by a patterning process to form a second gate metal layer. As shown in FIGS. 2, 4, and 7, the second gate metal layer may at least include the second plate 232 of the capacitor 23 located in the display region, and the third gate 224 of the second transistor 22.
(5) Preparing a second semiconductor layer on the base substrate. In some examples, a third insulation thin film, a fourth insulation thin film, and a second semiconductor thin film are deposited on the base substrate on which the aforementioned structure is formed, and the second semiconductor thin film is patterned by a patterning process to form a second semiconductor layer. As shown in FIGS. 2, 4, and 7, the second semiconductor layer may at least include the second active layer 220 of the second transistor 22 located in the display region. The third insulation thin film may form the first interlayer insulation layer 103 in the display region and the third inorganic insulation layer 103a in the signal access region. The fourth insulation thin film may form the first buffer layer 104 in the display region and the fourth inorganic insulation layer 104a in the signal access region.
(6) Preparing a third gate metal layer on the base substrate. In some examples, a fifth insulation thin film and a third conductive thin film are sequentially deposited on the base substrate on which the aforementioned structure is formed, and the third conductive thin film is patterned by a patterning process to form a third gate metal layer. As shown in FIGS. 2, 4, and 7, the third gate metal layer may at least include the second gate 223 of the second transistor 22 located in the display region, and the access connection line 44 and the first contact pad metal layer 311 of the contact pad 31 located in the signal access region. The access connection line 44 and the first contact pad metal layer 311 connected thereto may be of an integral structure connected to each other. The fifth insulation thin film may form the third gate insulation layer 105 in the display region and the fifth inorganic insulation layer 105a in the signal access region.

In some examples, after the third gate metal layer is formed, the fifth insulation thin film, the fourth insulation thin film, and the third insulation thin film of the signal access region may be etched to form the fifth inorganic insulation layer 105a, the fourth inorganic insulation layer 104a, and the third inorganic insulation layer 103a. For example, in the signal access region, the fifth insulation thin film, the fourth insulation thin film, and the third insulation thin film that are not shielded by the third gate metal layer may be etched away.

In some examples, a thickness of the fourth inorganic insulation layer 104a may be about 2000 angstroms to 4000 angstroms, and a thickness of the fifth inorganic insulation layer 105a may be about 1000 angstroms to 2000 angstroms. The present embodiment is not limited thereto.

(7) Preparing a second interlayer insulation layer and a sixth inorganic insulation layer on the base substrate. In some examples, a sixth insulation thin film is deposited on the base substrate on which the aforementioned structure is formed, and the sixth insulation thin film is patterned by a patterning process to form the second interlayer insulation layer 106 in the display region and the sixth inorganic insulation layer 106a in the signal access region. For example, the second interlayer insulation layer of the display region may be provided with a plurality of pixel vias (including, for example, a first pixel via to a fourth pixel via). The sixth inorganic insulation layer 106a of the signal access region may be provided with a plurality of vias (including, for example, a first via and a second via). In some examples, the sixth inorganic insulation layer 106a in the first signal access region B121 may be removed. In some examples, a thickness of the sixth inorganic insulation layer may be about 4000 angstroms and 6000 angstroms.

(8) Preparing a first source-drain metal layer on the base substrate. In some examples, a fourth conductive thin film is deposited on the base substrate on which the aforementioned structure is formed and the fourth conductive thin film is patterned by a patterning process to form a first source-drain metal layer. As shown in FIGS. 2, 4, and 7, the first source-drain metal layer may at least include the first source 211 and the first drain 212 of the first transistor 21 located in the display region, the second source 221 and the second drain 222 of the second transistor 22 located in the display region, and the connection electrode 45 and the second contact pad metal layer 312 of the contact pad 31 located in the signal access region. The first source 211 and the first drain 212 of the first transistor 21 may be connected to both ends of the first active layer 210 of the first transistor 21 through the first pixel via and the second pixel via, respectively, and the second source 221 and the second drain 222 of the second transistor 22 may be connected to both ends of the second active layer 220 of the second transistor 22 through the third pixel via and the fourth pixel via, respectively. The connection electrode 45 may be electrically connected to the data lead 41 located in the first gate metal layer and to the access connection line 44 located in the third gate metal layer through at least one first via K1 and at least one second via K2. Since the sixth inorganic insulation layer in the first signal access region is removed, the second contact pad metal layer 312 of the contact pad may be in direct contact with the first contact pad metal layer 311 located in the third gate metal layer to achieve electrical connection. The second contact pad metal layer 312 may cover an edge of the first contact pad metal layer 311 and may be in contact with a side edge of the inorganic composite insulation layer, thereby not only ensuring the stability of the stacking of the contact pad metal layers but also protecting the first contact pad metal layer 311.

(9) Preparing a second source-drain metal layer on the base substrate. In some examples, a seventh insulation thin film is deposited on the base substrate on which the aforementioned structure is formed to form a passivation layer 107, followed by coating an eighth insulation thin film, and the eighth insulation thin film is patterned by a patterning process to form a first planarization layer 108. For example, both the passivation layer 107 and the first planarization layer 108 of the signal access region may be removed. As shown in FIG. 2, the first planarization layer 108 of the display region may be provided with a fifth pixel via, and the passivation layer 107 and the first planarization layer 108 in the fifth pixel via may be removed to expose a part of a surface of the first drain 212 of the first transistor 21 of the pixel circuit.

In some examples, a sixth conductive thin film is deposited on the base substrate on which the aforementioned structure is formed and the sixth conductive thin film is patterned by a patterning process to form a second source-drain metal layer. As shown in FIGS. 2, 4, and 7, the second source-drain metal layer may at least include a first transfer electrode 241 located in the display region, and a third contact pad metal layer 313 of the contact pad 31 located in the signal access region. The first transfer electrode 241 may be electrically connected to the first drain 212 of the first transistor 21 of the pixel circuit through the fifth pixel via. Since both the passivation layer 107 and the first planarization layer 108 in the first signal access region are removed, the third contact pad metal layer 313 of the contact pad can be in direct contact with the second contact pad metal layer 312 located in the first source-drain metal layer to achieve electrical connection. The third contact pad metal layer 313 can cover an edge of the second contact pad metal layer 312, thereby not only ensuring the stability of the stacking of the contact pad metal layers, but also protecting the first contact pad metal layer 311 and the second contact pad metal layer 312.

(10) Preparing a second planarization layer on the base substrate. In some examples, a ninth insulation thin film is coated on the base substrate on which the aforementioned structure is formed, and the ninth insulation thin film is patterned by a patterning process to form a second planarization layer 109 located in the display region and a first organic insulation layer 109a located in the signal access region. As shown in FIG. 2, the second planarization layer 109 of the display region may be provided with a sixth pixel via, and the second planarization layer 109 in the sixth pixel via may be removed to expose a part of a surface of the first transfer electrode 241. The first organic insulation layer 109a of the signal access region may cover an edge of the third contact pad metal layer 311 and expose a part of a surface of the third contact pad metal layer 311 away from the base substrate 10. The first organic insulation layer 109a between adjacent contact pads may be removed.

So far, the preparation of the circuit structure layer of the display region has been completed on the base substrate.

In some examples, the first insulation thin film, the second insulation thin film, the third insulation thin film, the fourth insulation thin film, the fifth insulation thin film, the sixth insulation thin film, and the seventh insulation thin film may be made of inorganic material, for example, may be made of any one or more of silicon oxide (SiOx, x>0), silicon nitride (SiNy, y>0) and silicon oxynitride (SiON), and may be a single layer, multiple layers or a composite layer. The eighth insulation thin film and the ninth insulation thin film may be made of an organic material, for example, an organic material such as polyimide, acrylic, or polyethylene terephthalate may be used. The first gate metal layer, the second gate metal layer, and the third gate metal layer may be made of a metal material, such as any one or more of silver (Ag), copper (Cu), aluminum (Al), titanium (Ti), and molybdenum (Mo), and may be of a single-layered structure. For example, the first gate metal layer, the second gate metal layer, and the third gate metal layer may each include a Mo metal layer. The first source-drain metal layer and the second source-drain metal layer may be made of a metal material, such as any one or more of silver (Ag), copper (Cu), aluminum (Al), titanium (Ti) and molybdenum (Mo), or an alloy material of the aforementioned metals, such as an aluminum neodymium alloy (AlNd) or a molybdenum niobium alloy (MoNb), and may be of a single-layered structure or a multi-layered composite structure, such as Ti/Al/Ti. For example, the first source-drain metal layer and the second source-drain metal layer may employ a three-layer stacked structure of Ti/Al/Ti. The first semiconductor layer may be made of one or more materials such as amorphous silicon (a-Si), polysilicon (p-Si), hexathiophene, and polythiophene, and the second semiconductor layer may be made of one or more materials such as amorphous indium gallium zinc oxide material (a-IGZO), zinc oxynitride (ZnON), and indium zinc tin oxide (IZTO). That is, the present disclosure is applicable to transistors manufactured based on Oxide technology, silicon technology, and organic technology. The present embodiment is not limited thereto.

(11) Preparing a light emitting structure layer on the base substrate. In some examples, a transparent conductive thin film is deposited on the base substrate 10 on which the aforementioned structure is formed and the transparent conductive thin film is patterned by a patterning process to form a pattern of a first electrode 131 of the light emitting element. A pixel definition thin film is coated on the base substrate 10 on which the aforementioned structure is formed, and a pattern of a pixel definition layer (PDL) 134 is formed through masking, exposure, and development processes. As shown in FIG. 2, the pixel definition layer 134 of the display region AA is provided with a pixel opening, and a pixel definition thin film in the pixel opening is developed away to expose at least part of a surface of the first electrode 131. For example, the pixel definition layer 134 may be made of an organic material, such as polyimide, acrylic, or polyethylene terephthalate.

Subsequently, the organic light emitting layer 132 and the second electrode 133 are sequentially formed on the base substrate 10 on which the aforementioned patterns are formed. As shown in FIG. 2, the organic light emitting layer 132 may include a hole injection layer, a hole transport layer, a light emitting layer, an electron transport layer, and an electron injection layer which are stacked, and is formed in a pixel opening of the display region AA to achieve a connection between the organic light emitting layer 132 and the first electrode 131. Since the first electrode 131 is connected to the first drain 212 of the first transistor 21, light emission control of the organic light emitting layer 132 is achieved. A portion of the second electrode 133 may be formed on the organic light emitting layer 132. After the light emitting structure layer 13 is formed in the display region AA, the film layer structure of the signal access region may not change.

(12) Preparing an encapsulation structure layer. In some examples, an encapsulation structure layer 14 is formed on the base substrate 10 on which the aforementioned patterns are formed. As shown in FIG. 2, the encapsulation structure layer 14 may be formed in the display region AA and may adopt a stacked structure of an inorganic material/an organic material/an inorganic material. An organic material layer may be disposed between two inorganic material layers. After the encapsulation structure layer 14 is formed, the film layer structure of the signal access region may not change.

(13) Preparing a touch structure layer. In some examples, a first touch insulation thin film is deposited on the base substrate on which the aforementioned structure is formed, and the first touch insulation thin film is patterned by a patterning process to form a touch buffer layer 150, as shown in FIGS. 2 and 4. The touch buffer layer of the signal access region may be provided with a via that exposes a surface of the third contact pad metal layer 313. In some examples, the touch buffer layer 150 may be made of an inorganic insulation material, for example, may be made of any one or more of silicon oxide (SiOx, x > 0), silicon nitride (SiNy, y > 0), and silicon oxynitride (SiON), and may be a single layer, multiple layers, or a composite layer.

Subsequently, a first touch conductive thin film is deposited, and the first touch conductive thin film is patterned by a patterning process to form a first touch conductive layer 151. For example, the first touch conductive layer may at least include a touch electrode located in the display region. After the first touch conductive layer is formed, the film layer structure of the signal access region may not change.

Subsequently, a touch interlayer insulation thin film is coated, and the touch interlayer insulation thin film is patterned by a patterning process to form a touch interlayer insulation layer 153 covering the first touch conductive layer 151. The touch interlayer buffer layer 153 in the signal access region may be provided with a via exposing a surface of the third contact pad metal layer 313. In some examples, the touch interlay insulation layer 153 may be made of an inorganic insulation material, for example, may be made of any one or more of silicon oxide (SiOx, x > 0), silicon nitride (SiNy, y > 0), and silicon oxynitride (SiON), and may be a single layer, multiple layers, or a composite layer.

Subsequently, a second touch conductive thin film is deposited, and the second touch conductive thin film is patterned by a patterning process to form a second touch conductive layer 152 on the touch interlayer insulation layer 153. For example, as shown in FIGS. 2, 4, and 7, the second touch conductive layer 152 may at least include a second connection portion located in the display region and a fourth contact pad metal layer 314 located in the signal access region. The fourth contact pad metal layer 314 may be connected to the third contact pad metal layer 313 located in the second source-drain metal layer through vias formed in the touch interlayer insulation layer 153, the touch buffer layer 150, and the first organic insulation layer 109a.

In some examples, the first and second touch conductive layers 151 and 152 may be made of a metal material, such as any one or more of silver (Ag), copper (Cu), aluminum (Al), titanium (Ti), and molybdenum (Mo), may be of a single-layered structure, or may be of a stacked structure.

Subsequently, a protective thin film is coated, and the protective thin film is patterned by a patterning process to form a protection layer 154. For example, the protection layer 154 of the first signal access region may be removed to expose a surface of the fourth contact pad metal layer 314 to facilitate bonding and connection of the drive chip.

The contact pad of this example may include four contact pad metal layers that are stacked. By forming the contact pad through providing a plurality of stacked contact pad metal layers, it is beneficial to reducing the resistance of the contact pad and improving the signal transmission performance of the contact pad.

Through research, the inventors have found that the pixel circuit of the display panel of this example includes two different types of transistors compared with a display panel in which a plurality of transistors of the pixel circuit are of the same type. Thus, a film layer in which the second active layer and the second gate of the second transistor are located, a film layer between the second active layer and the second gate, and an insulation layer between the second active layer and the second gate and other conductive film layers are added to the display structure layer. For example, the newly added film layers may include a first buffer layer 104, a third gate insulation layer 105, and a second interlayer insulation layer 106. A thickness of the first buffer layer 104 may be about 2000 angstroms to 4000 angstroms, a thickness of the third gate insulation layer 105 may be about 1000 angstroms to 2000 angstroms, and a thickness of the second interlayer insulation layer 106 may be about 4000 angstroms to 6000 angstroms, so that the total thickness of the newly added film layers may be about 9000 angstroms to 1 micron. When these newly added film layers are provided in the signal access region, they will affect the height difference between the contact pad and the peripheral film layer, thus causing the risk of crack of the peripheral film layer of the contact pad in the bonding process of the drive chip and affecting the product yield. In this example, the setting mode of these newly added film layers in the signal access region is adjusted to improve the height difference between the contact pad and the peripheral film layer, thereby reducing the risk of cracks in the peripheral film layer of the contact pad in the bonding process of the drive chip.

In the display panel of this example, the height of the contact pad can be increased by using the inactive contact pad metal layer and the inorganic composite insulation layer, thereby reducing the height difference between the contact pad and the peripheral film layer, alleviating the crack of the film layer occurring during the bonding process of the drive chip, and improving the stability of the bonding process and the product yield.

In the display panel of this example, by removing a part of the inorganic composite insulation layer in the spacing region of the adjacent contact pads, it is beneficial to reducing the height difference between the contact pad and the peripheral film layer, thereby alleviating the crack of the film layer occurring during the bonding process of the drive chip, and improving the stability of the bonding process and the product yield.

In the display panel of this example, by removing the sixth inorganic insulation layer in the first signal access region, it may be beneficial to reducing the height difference between the contact pad and the peripheral film layer, and it is possible to avoid the risk of circuit breaking due to metal overetching caused by the etching process for the sixth inorganic insulation layer in the first signal access region, thereby improving the stability of the bonding process and the product yield.

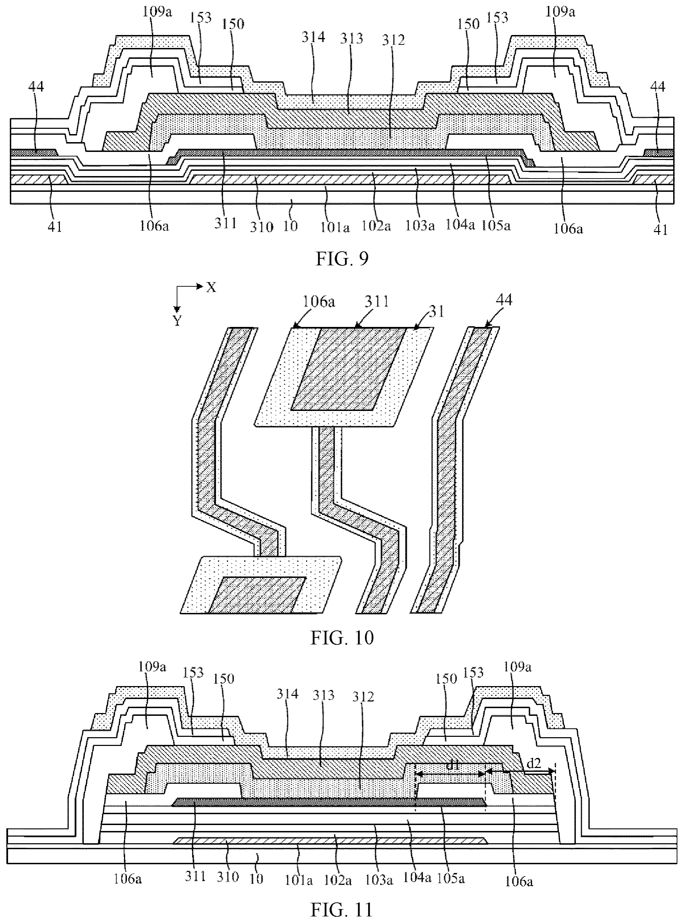

FIG. 8 is an example of a partially enlarged view of the region S2 in FIG. 3. FIG. 9 is another schematic partial cross-sectional view taken along the direction P-P' in FIG. 3.

In some examples, as shown in FIGS. 8 and 9, one contact pad 31 may include four contact pad metal layers that are stacked, including, for example, a first contact pad metal layer 311, a second contact pad metal layer 312, a third contact pad metal layer 313, and a fourth contact pad metal layer 314. The first contact pad metal layer 311, the second contact pad metal layer 312, the third contact pad metal layer 313, and the fourth contact pad metal layer 314 may be sequentially arranged along a direction away from the base substrate 10. The second contact pad metal layer 312 may be in contact with the first contact pad metal layer 311 through a via formed in the sixth inorganic insulation layer 106a. For example, an orthographic projection of the second contact pad metal layer 312 on the base substrate 10 may cover an orthographic projection of the first contact pad metal layer 311 on the base substrate 10. The third contact pad metal layer 313 may be in direct contact with the second contact pad metal layer 312, an orthographic projection of the third contact pad metal layer 313 on the base substrate 10 may cover the orthographic projection of the second contact pad metal layer 312 on the base substrate 10, and the third contact pad metal layer 313 may cover an edge of the second contact pad metal layer 312. An orthographic projection of the fourth contact pad metal layer 314 on the base substrate 10 may cover the orthographic projection of the third contact pad metal layer 313 on the base substrate 10. The fourth contact pad metal layer 314 may be in contact with the third contact pad metal layer 313 through vias formed in the first organic insulation layer 109a, the touch buffer layer 150, and the touch interlayer insulation layer 153. The contact pad 31 may further include an inactive contact pad metal layer 310 located on a side of the first contact pad metal layer 311 close to the base substrate 10.

In some examples, as shown in FIGS. 8 and 9, the sixth inorganic insulation layer 106a of the signal access region may be provided in the spacing between adjacent contact pads 31. For example, the sixth inorganic insulation layer 106a may cover an edge of the first contact pad metal layer 311 of the contact pad 31, and may also cover the access connection line 44.

In some examples, as shown in FIGS. 8 and 9, both the data lead 41 and the access connection line 44 extend between adjacent contact pads 31 of the first signal access region. A second inorganic insulation layer 102a, a third inorganic insulation layer 103a, a fourth inorganic insulation layer 104a, and a fifth inorganic insulation layer 105a may be sequentially arranged between the data lead 41 and the access connection line 44. A second inorganic insulation layer 102a, a third inorganic insulation layer 103a, a fourth inorganic insulation layer 104a, and a fifth inorganic insulation layer 105a may be sequentially arranged between the first contact pad metal layer 311 and the inactive contact pad metal layer 310. The inorganic composite insulation layer of this example may include a second inorganic insulation layer 102a, a third inorganic insulation layer 103a, a fourth inorganic insulation layer 104a, and a fifth inorganic insulation layer 105a. An orthographic projection of the inorganic composite insulation layer on the base substrate may cover an orthographic projection of the contact pad on the base substrate. The orthographic projection of the inorganic composite insulation layer on the base substrate may cover the spacing between adjacent contact pads. In some examples, a thickness of the inorganic composite insulation layer located below the first contact pad metal layer 311 may be substantially the same as a thickness of the inorganic composite insulation layer in the spacing region between adjacent contact pads. In other examples, the thickness of the inorganic composite insulation layer located below the first contact pad metal layer 311 may be greater than the thickness of the inorganic composite insulation layer in the spacing region between adjacent contact pads. For example, the inorganic composite insulation layer in the spacing region between adjacent contact pads may be subjected to a thinning treatment, such as reducing the thickness of at least one film layer of the third inorganic insulation layer 103a, the fourth inorganic insulation layer 104a, and the fifth inorganic insulation layer 105a in the inorganic composite insulation layer.

In the display panel of this example, the height of the contact pad may be increased by using the inactive contact pad metal layer located in the first gate metal layer, or by using the inactive contact pad metal layer and the inorganic composite insulation layer, thereby reducing the height difference between the contact pad and the peripheral film layer, alleviating the crack of the film layer occurring during the bonding process of the drive chip, and improving the stability of the bonding process and the product yield.

The rest of the structure of the display panel in the example may refer to the description of the aforementioned embodiments, which will not be repeated here.

FIG. 10 is another example of a partially enlarged view of the region S2 in FIG. 3. FIG. 11 is another schematic partial cross-sectional view taken along the direction P-P' in FIG. 3.

In some examples, as shown in FIGS. 10 and 11, one contact pad 31 may include four contact pad metal layers that are stacked, including, for example, a first contact pad metal layer 311, a second contact pad metal layer 312, a third contact pad metal layer 313, and a fourth contact pad metal layer 314 sequentially arranged along a direction away from the base substrate 10. The contact pad 31 may further include an inactive contact pad metal layer 310 located on a side of the first contact pad metal layer 311 close to the base substrate 10. A second inorganic insulation layer 102a, a third inorganic insulation layer 103a, a fourth inorganic insulation layer 104a, and a fifth inorganic insulation layer 105a may be sequentially arranged between the inactive contact pad metal layer 310 and the first contact pad metal layer 311. The inorganic composite insulation layer of this example may include a second inorganic insulation layer 102a, a third inorganic insulation layer 103a, a fourth inorganic insulation layer 104a, and a fifth inorganic insulation layer 105a. An orthographic projection of the inorganic composite insulation layer on the base substrate may at least cover orthographic projections of the overlapping regions of the four contact pad metal layers and the inactive contact pad metal layer of the contact pad on the base substrate. A side edge of the inorganic composite insulation layer may be in contact with the first organic insulation layer 109a.

In some examples, as shown in FIGS. 10 and 11, a sixth inorganic insulation layer 106a may be provided between the first contact pad metal layer 311 and the second contact pad metal layer 312 of the contact pad 31, and the sixth inorganic insulation layer 106a may cover an edge of the first contact pad metal layer 311. The sixth inorganic insulation layer 106a may be provided with a via exposing a surface of a middle portion of the first contact pad metal layer 311, so that the second contact pad metal layer 312 is connected to the first contact pad metal layer 311. The sixth inorganic insulation layer 106a may form an annular structure, for example, a quadrangular annular structure, surrounding an edge of the first contact pad metal layer 311. The sixth inorganic insulation layer 106a may also cover an edge of the access connection line 44 and expose a middle portion of the access connection line 44. In other words, an edge of the second gate metal layer in the first signal access region may be covered by the sixth inorganic insulation layer 106a. The sixth inorganic insulation layer 106a may not be provided in the spacing between the contact pad and the adjacent access connection lines and in the spacing between the adjacent access connection lines.

In some examples, as shown in FIG. 11, a covering length of the sixth inorganic insulation layer 106a for a single-side edge of the first contact pad metal layer 311 may be a first length d1. The first length d1 may be about 2.5 microns to 3.5 microns, for example, may be about 3 microns. A length of the sixth inorganic insulation layer 106a at the single-side edge of the first contact pad metal layer 311 and not covering the first contact pad metal layer 311 may be a second length d2. The second length may be about 1 micron to 2 microns, for example, may be about 1.5 microns. A covering length of the sixth inorganic insulation layer 106a for a single-side edge of the access connection line may be less than the covering length of the sixth inorganic insulation layer 106a for the single-side edge of the first contact pad metal layer, and a length of the sixth inorganic insulation layer 106a at the single-side edge of the access connection line and not covering the access connection line may be substantially the same as the second length. The present embodiment is not limited thereto.

In the display panel of this example, the edge of the first contact pad metal layer of the contact pad can be annularly covered and protected by using the sixth inorganic insulation layer. In this example, the sixth inorganic insulation layer is partially provided in the spacing between the adjacent contact pads and is not connected as a whole, and the inorganic composite insulation layer is also partially provided in the spacing between the adjacent contact pads and is not connected as a whole, so that the crack propagation path of the inorganic film layer in the bonding process of the drive chip can be cut off, thereby playing a role of preventing the cracks.

The rest of the structure of the display panel in the example may refer to the description of the aforementioned embodiments, which will not be repeated here.

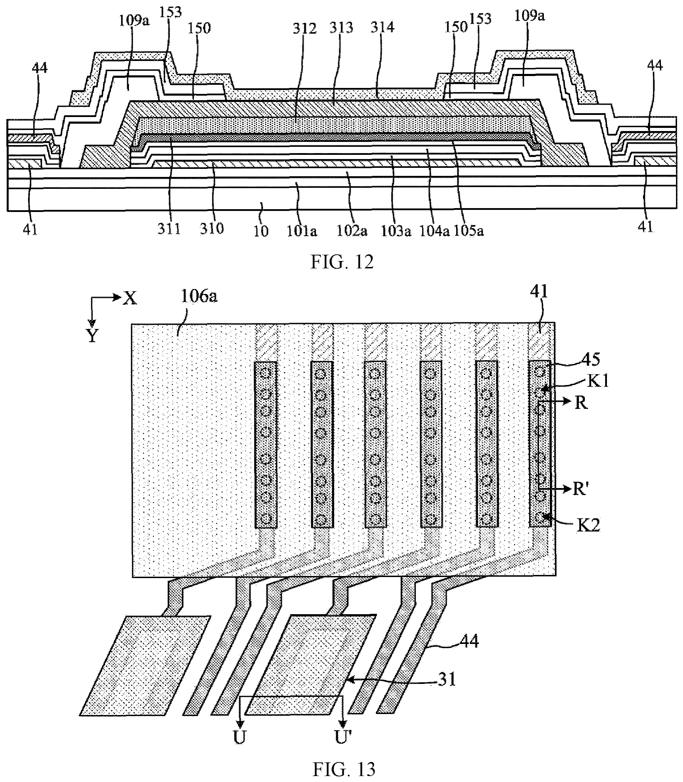

FIG. 12 is another schematic partial cross-sectional view along the direction P-P' in FIG. 3. In some examples, as shown in FIG. 12, one contact pad 31 may include four contact pad metal layers that are stacked, including, for example, a first contact pad metal layer 311, a second contact pad metal layer 312, a third contact pad metal layer 313, and a fourth contact pad metal layer 314 sequentially arranged along a direction away from the base substrate 10. The first contact pad metal layer 311 may be located in the third gate metal layer, the second contact pad metal layer 312 may be located in the first source-drain metal layer, the third contact pad metal layer 313 may be located in the second source-drain metal layer, and the fourth contact pad metal layer 314 may be located in the second touch conductive layer. The contact pad 31 may further include an inactive contact pad metal layer 310 located on a side of the first contact pad metal layer 311 close to the base substrate 10. The inactive contact pad metal layer 310 may be located in the second gate metal layer.

In some examples, as shown in FIG. 12, a third inorganic insulation layer 103a, a fourth inorganic insulation layer 104a, and a fifth inorganic insulation layer 105a may be sequentially arranged between the inactive contact pad metal layer 310 and the first contact pad metal layer 311 along a direction away from the base substrate 10. The inactive contact pad metal layer 310 and one data lead 41 may be of an integral structure connected to each other, and the first contact pad metal layer 311 and the access connection line 44 connected thereto may be of an integral connected to each other. A third inorganic insulation layer 103a, a fourth inorganic insulation layer 104a, and a fifth inorganic insulation layer 105a may be provided between the data lead 41 and the access connection line 44.

In some examples, as shown in FIG. 12, the inorganic composite insulation layer may include a third inorganic insulation layer 103a, a fourth inorganic insulation layer 104a, and a fifth inorganic insulation layer 105a sequentially arranged along a direction away from the base substrate 10. An orthographic projection of the inorganic composite insulation layer on the base substrate may at least cover orthographic projections of the overlapping regions of the four contact pad metal layers and the inactive contact pad metal layer 310 of the contact pad on the base substrate 10. The inorganic composite insulation layer may be partially disposed in the spacing between adjacent contact pads. The inorganic composite insulation layer in the spacing between the contact pad and the adjacent access connection line and in the spacing between the adjacent access connection lines may be removed. A side edge of the inorganic composite insulation layer is in contact with the third contact pad metal layer 313. The third contact pad metal layer 313 may cover edges of the second contact pad metal layer 312 and the first contact pad metal layer 311 on the base substrate 10, thereby maintaining structural stability of the contact pad and protecting the first contact pad metal layer 311 and the second contact pad metal layer 312.

In some examples, as shown in FIG. 12, the sixth inorganic insulation layer of the first signal access region may be entirely removed. The second contact pad metal layer 312 may be in direct contact with the first contact pad metal layer 311.

In the display panel of this example, the height of the contact pad can be increased by using the inactive contact pad metal layer and the inorganic composite insulation layer located in the second gate metal layer, and the sixth inorganic insulation layer in the first signal access region is entirely removed, thereby reducing the height difference between the contact pad and the peripheral film layer, alleviating the crack of the film layer occurring during the bonding process of the drive chip, and improving the stability of the bonding process and the product yield.

The rest of the structure of the display panel in the example may refer to the description of the aforementioned embodiments, which will not be repeated here.

In other examples, the features of the aforementioned embodiments may be combined with each other. For example, the first contact pad metal layer of the contact pad may be located in the third gate metal layer, the inactive contact pad metal layer may be located in the second gate metal layer, the sixth inorganic insulation layer may cover an edge of the first contact pad metal layer, or the sixth inorganic insulation layer may form an annular structure covering the edge of the first contact pad metal layer.

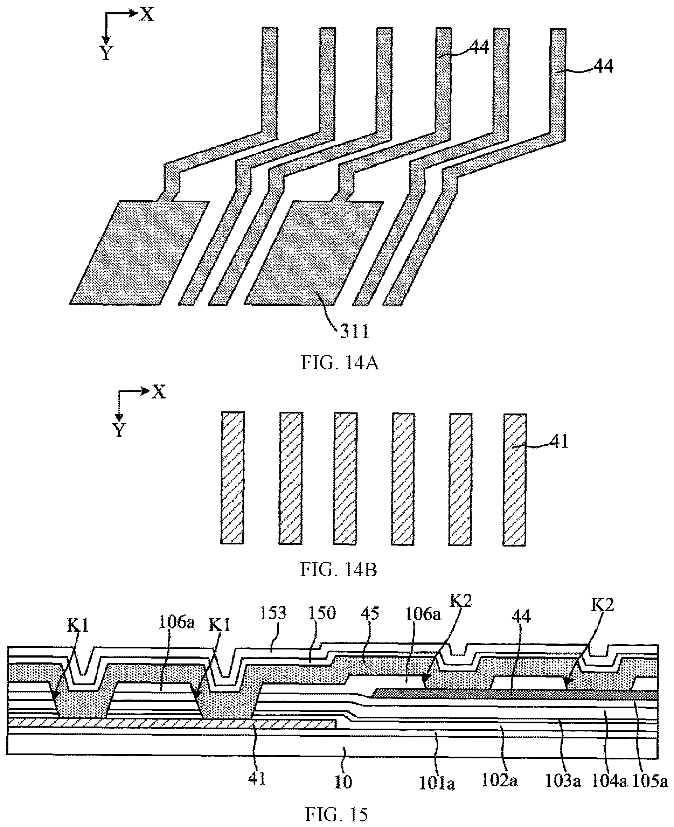

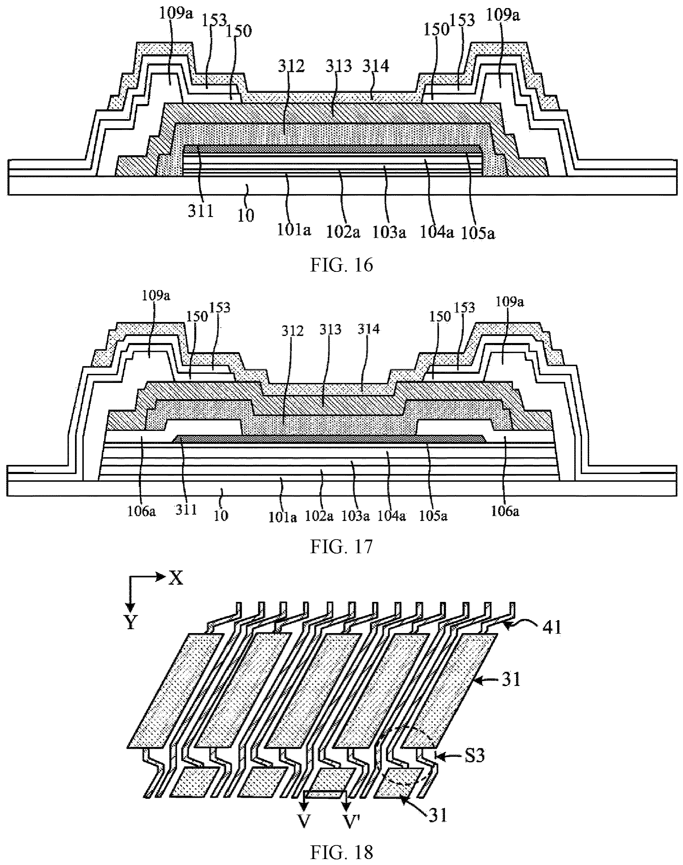

FIG. 13 is another example of a partially enlarged view of the region S1 in FIG. 3. FIG. 14A is a schematic view of a third gate metal layer in FIG. 13. FIG. 14B is a schematic view of a first gate metal layer in FIG. 13. FIG. 15 is a schematic partial cross-sectional view taken along the direction R-R' in FIG. 13. FIG. 16 is another example of a partial cross-sectional view taken along the direction P-P' in FIG. 3.

In some examples, as shown in FIGS. 13 to 16, the plurality of data leads 41 do not extend between adjacent contact pads 31, nor do they extend below the contact pads 31. The plurality of data leads 41 are electrically connected to the plurality of access connection lines 44, and the plurality of access connection lines 44 are electrically connected to the plurality of contact pads 31. The plurality of data leads 41 may be electrically connected to the plurality of contact pads 31 through the plurality of access connection lines 44.

In some examples, as shown in FIGS. 13-16, the plurality of data leads 41 may be located in the first gate metal layer, and the plurality of access connection lines 44 may be located in the third gate metal layer. For example, an orthographic projection of the access connection line 44 on the base substrate may not overlap with an orthographic projection of the data lead 41 on the base substrate. The data lead 41 may be electrically connected to the access connection line 44 through the connection electrode 45. For example, one end of the connection electrode 45 located in the first source-drain metal layer may be electrically connected to the data lead 41 located in the first gate metal layer through a plurality of first vias K1, and the other end of the connection electrode 45 located in the first source-drain metal layer may be electrically connected to the access connection line 44 located in the third gate metal layer through a plurality of second vias K2.

In some examples, as shown in FIG. 16, one contact pad 31 may include four contact pad metal layers that are stacked, including, for example, a first contact pad metal layer 311, a second contact pad metal layer 312, a third contact pad metal layer 313, and a fourth contact pad metal layer 314 sequentially arranged along a direction away from the base substrate 10. The first contact pad metal layer 311 may be located in the third gate metal layer, and the first contact pad metal layer 311 and the access connection line 44 connected thereto may be of an integral structure connected to each other. A fifth inorganic insulation layer 105a, a fourth inorganic insulation layer 104a, a third inorganic insulation layer 103a, a second inorganic insulation layer 102a, and a first inorganic insulation layer 101a are sequentially arranged along direction close to the base substrate 10 on a side of the first contact pad metal layer 311 close to the base substrate 10. The inorganic composite insulation layer of this example may include, for example, a fifth inorganic insulation layer 105a, a fourth inorganic insulation layer 104a, a third inorganic insulation layer 103a, a second inorganic insulation layer 102a, and a first inorganic insulation layer 101a. An orthographic projection of the inorganic composite insulation layer on the base substrate 10 may cover orthographic projections of overlapping regions of the four contact pad metal layers of the contact pad on the base substrate 10. The inorganic composite insulation layer may be partially disposed in the spacing between adjacent contact pads. For example, the orthographic projection of the inorganic composite insulation layer on the base substrate may overlap with the orthographic projection of the access connection line on the base substrate. The inorganic composite insulation layer in the spacing between the contact pad and the adjacent access connection line and in the spacing between the adjacent access connection lines may be removed. A side edge of the inorganic composite insulation layer is in contact with the second contact pad metal layer 312.

In some examples, as shown in FIG. 16, the contact pad does not include an inactive contact pad metal layer. However, the present embodiment is not limited thereto. In other examples, an inactive contact pad metal layer that does not have electrical connection relationships may be separately provided. For example, the inactive contact pad metal layer may be located in the first gate metal layer or the second gate metal layer, thereby utilizing the inactive contact pad metal layer to increase the height of the contact pad.

In some examples, as shown in FIG. 16, the second contact pad metal layer 312 may be in direct contact with the first contact pad metal layer 311. The sixth inorganic insulation layer of the first signal access region may be entirely removed.

In the display panel of this example, the height of the contact pad can be increased by using the inorganic composite insulation layer located below the first contact pad metal layer, thereby reducing the height difference between the contact pad and the peripheral film layer, alleviating the crack of the film layer occurring during the bonding process of the drive chip, and improving the stability of the bonding process and the product yield.

In the display panel of this example, the inorganic composite insulation layer is partially provided in the spacing between the adjacent contact pads and is not connected as a whole, so that the crack propagation path of the inorganic film layer in the bonding process of the drive chip can be cut off, thus playing a role of preventing the crack.

The rest of the structure of the display panel in the example may refer to the description of the aforementioned embodiments, which will not be repeated here.

FIG. 17 is another example of a partial cross-sectional view taken along the direction P-P' in FIG. 3. In some examples, as shown in FIG. 17, one contact pad 31 may include four contact pad metal layers that are stacked, including, for example, a first contact pad metal layer 311, a second contact pad metal layer 312, a third contact pad metal layer 313, and a fourth contact pad metal layer 314 sequentially arranged along a direction away from the base substrate 10. The first contact pad metal layer 311 may be located in the third gate metal layer. The contact pad 31 of this example may not be provided with an inactive contact pad metal layer.

In some examples, as shown in FIG. 17, the inorganic composite insulation layer may include, for example, a fifth inorganic insulation layer 105a, a fourth inorganic insulation layer 104a, a third inorganic insulation layer 103a, a second inorganic insulation layer 102a, and a first inorganic insulation layer 101a. An orthographic projection of the inorganic composite insulation layer on the base substrate 10 may cover orthographic projections of overlapping regions of the four contact pad metal layers of the contact pad on the base substrate 10. A side edge of the inorganic composite insulation layer is in contact with the first organic insulation layer 109a. A sixth inorganic insulation layer 106a may be provided between the second contact pad metal layer 312 and the first contact pad metal layer 311. The sixth inorganic insulation layer 106a may cover an edge of the first contact pad metal layer 311, and the first contact pad metal layer 311 may be electrically connected to the second contact pad metal layer 312 through a via formed in the sixth inorganic insulation layer 106a. For example, the sixth inorganic insulation layer 106a may annularly cover and protect the edge of the first contact pad metal layer 311.

In the display panel of this example, the height of the contact pad can be increased by using the inorganic composite insulation layer located below the first contact pad metal layer, thereby reducing the height difference between the contact pad and the peripheral film layer, alleviating the crack of the film layer occurring during the bonding process of the drive chip, and improving the stability of the bonding process and the product yield. The edge of the first contact pad metal layer of the contact pad can be annularly covered and protected by the sixth inorganic insulation layer. In this example, the sixth inorganic insulation layer is partially provided in the spacing between the adjacent contact pads and is not connected as a whole, and the inorganic composite insulation layer is also partially provided in the spacing between the adjacent contact pads and is not connected as a whole, so that the crack propagation path of the inorganic film layer in the bonding process of the drive chip can be cut off, thereby playing a role of preventing the cracks.

The rest of the structure of the display panel in the example may refer to the description of the aforementioned embodiments, which will not be repeated here.

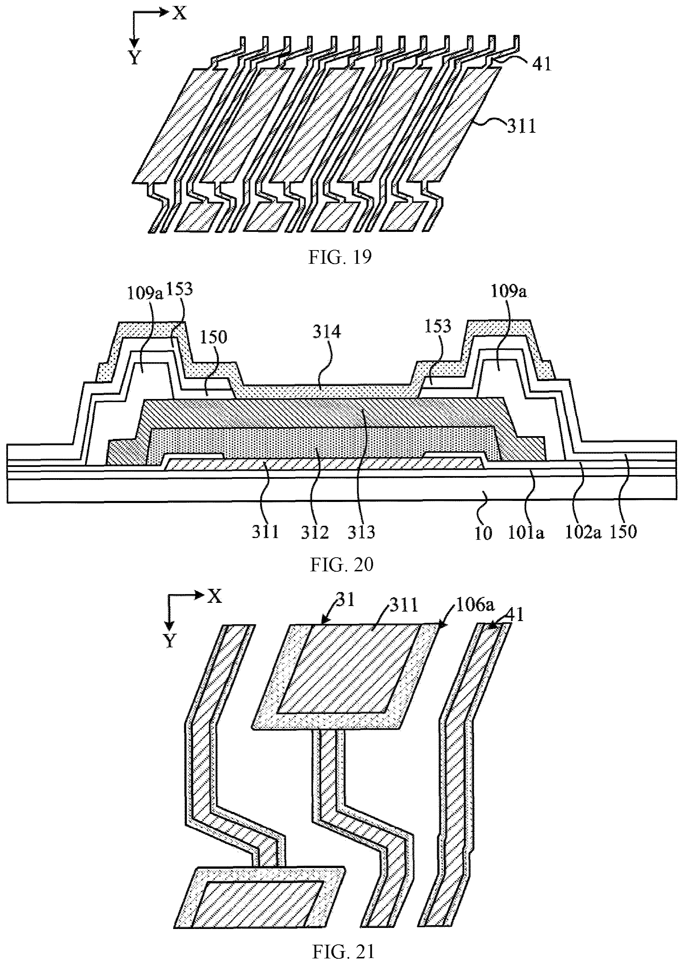

FIG. 18 is another schematic partial view of a signal access region according to at least one embodiment of the present disclosure. FIG. 19 is a schematic view of a first gate metal layer in FIG. 18. FIG. 20 is a schematic partial cross-sectional view taken along a direction V-V' in FIG. 18.

In some examples, as shown in FIGS. 18 to 20, one first contact pad 31 may include four contact pad metal layers that are stacked, including, for example, a first contact pad metal layer 311, a second contact pad metal layer 312, a third contact pad metal layer 313, and a fourth contact pad metal layer 314. The first contact pad metal layer 311, the second contact pad metal layer 312, the third contact pad metal layer 313, and the fourth contact pad metal layer 314 may be sequentially arranged along a direction away from the base substrate 10. The first contact pad metal layer 311 may be located in the first gate metal layer, the second contact pad metal layer 312 may be located in the first source-drain metal layer, the third contact pad metal layer 313 may be located in the second source-drain metal layer, and the fourth contact pad metal layer 314 may be located in the second touch conductive layer.

In some examples, as shown in FIG. 19, the data lead 41 may extend between adjacent contact pads. The data lead 41 and the first contact pad metal layer 311 of the contact pad connected thereto may be of an integral structure connected to each other.

In some examples, as shown in FIG. 20, the second contact pad metal layer 312 may be connected to the first contact pad metal layer 311 through a via formed in the second inorganic insulation layer 102a. An orthographic projection of the second contact pad metal layer 312 on the base substrate may cover an orthographic projection of the first contact pad metal layer 311 on the base substrate. The second inorganic insulation layer 102a may cover an edge of the first contact pad metal layer 311.

In this example, the third inorganic insulation layer, the fourth inorganic insulation layer, the fifth inorganic insulation layer, and the sixth inorganic insulation layer of the first signal access region may be removed in manner of entire surface. The inorganic composite insulation layer of this example may include a third inorganic insulation layer, a fourth inorganic insulation layer, and a fifth inorganic insulation layer.

In this example, by removing the third inorganic insulation layer, the fourth inorganic insulation layer, the fifth inorganic insulation layer, and the sixth inorganic insulation layer in the first signal access region, the height difference between the contact pad and the peripheral film layer can be reduced, thereby alleviating the crack of the film layer occurring during the bonding process of the drive chip, and improving the stability of the bonding process and the product yield.

The rest of the structure of the display panel in the example may refer to the description of the aforementioned embodiments, which will not be repeated here.

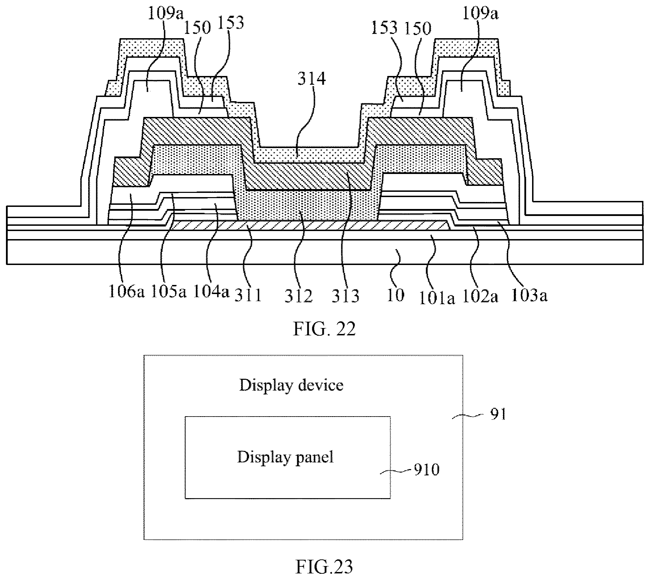

FIG. 21 is a partially enlarged schematic view of a region S3 in FIG. 18. FIG. 22 is another example of a partial cross-sectional view taken along the direction V-V' in FIG. 18.

In some examples, as shown in FIGS. 21 and 22, one first contact pad 31 may include four contact pad metal layers that are stacked, including, for example, a first contact pad metal layer 311, a second contact pad metal layer 312, a third contact pad metal layer 313, and a fourth contact pad metal layer 314. The first contact pad metal layer 311, the second contact pad metal layer 312, the third contact pad metal layer 313, and the fourth contact pad metal layer 314 may be sequentially arranged along a direction away from the base substrate 10. The first contact pad metal layer 311 may be located in the first gate metal layer, the second contact pad metal layer 312 may be located in the first source-drain metal layer, the third contact pad metal layer 313 may be located in the second source-drain metal layer, and the fourth contact pad metal layer 314 may be located in the second touch conductive layer.

In some examples, as shown in FIG. 22, a sixth inorganic insulation layer 106a, a fifth inorganic insulation layer 105a, a fourth inorganic insulation layer 104a, a third inorganic insulation layer 103a, and a second inorganic insulation layer 102a may be provided between the second contact pad metal layer 312 and the first contact pad metal layer 311. The second contact pad metal layer 312 may be connected to the first contact pad metal layer 311 through vias formed in the sixth inorganic insulation layer 106a, the fifth inorganic insulation layer 105a, the fourth inorganic insulation layer 104a, the third inorganic insulation layer 103a, and the second inorganic insulation layer 102a. The sixth inorganic insulation layer 106a, the fifth inorganic insulation layer 105a, the fourth inorganic insulation layer 104a, the third inorganic insulation layer 103a, and the second inorganic insulation layer 102a may cover an edge of the first contact pad metal layer 311. For example, the second inorganic insulation layer 102a may cover the spacing between adjacent contact pads; and the sixth inorganic insulation layer 106a, the fifth inorganic insulation layer 105a, the fourth inorganic insulation layer 104a, and the third inorganic insulation layer 103a may not be provided in the spacing between adjacent contact pads. The sixth inorganic insulation layer 106a, the fifth inorganic insulation layer 105a, the fourth inorganic insulation layer 104a, and the third inorganic insulation layer 103a may be stacked to form an annular structure covering the edge of the first contact pad metal layer 311. In this example, the inorganic composite insulation layer may include a third inorganic insulation layer 103a, a fourth inorganic insulation layer 104a, and a fifth inorganic insulation layer 105a. A side edge of the inorganic composite insulation layer is in contact with the first organic insulation layer 109a. The inorganic composite insulation layer of this example may annularly cover and protect the edge of the first contact pad metal layer 311, and the sixth inorganic insulation layer 106a may annularly cover and protect the edge of the first contact pad metal layer 311.

In some examples, the total thickness of the sixth inorganic insulation layer 106a, the fifth inorganic insulation layer 105a, and the fourth inorganic insulation layer 104a covering the edge of the first contact pad metal layer may be 4500 angstroms to 1 micron, for example, may be about 9000 angstroms. For example, the sixth inorganic insulation layer 106a, the fifth inorganic insulation layer 105a, and the fourth inorganic insulation layer 104a in the signal access region may be thinned to reduce the height difference between the contact pad and the peripheral film layer.

In display panel of this example, the sixth inorganic insulation layer is partially provided in the spacing between the adjacent contact pads and is not connected as a whole, and the inorganic composite insulation layer is also partially provided in the spacing between the adjacent contact pads and is not connected as a whole, so that the crack propagation path of the inorganic film layer in the bonding process of the drive chip can be cut off, thereby playing a role of preventing the cracks.

The rest of the structure of the display panel in the example may refer to the description of the aforementioned embodiments, which will not be repeated here.

The present embodiment further provides a display panel including a base substrate, a display structure layer, a plurality of data leads, a plurality of contact pads, an inorganic composite insulation layer, and a first organic insulation layer. The base substrate includes a display region and a signal access region located on at least one side of the display region. The display structure layer is located on the base substrate of the display region, and the display structure layer includes a plurality of sub-pixels and a plurality of data lines electrically connected to the plurality of sub-pixels, the plurality of data lines are configured to provide data signals to the plurality of sub-pixels. The plurality of data leads are located in the signal access region, and the plurality of data leads are connected to the plurality of data lines. The plurality of contact pads are located in the signal access region, at least one contact pad of the plurality of contact pads includes a plurality of contact pad metal layers electrically connected to each other, and the plurality of contact pad metal layers are electrically connected to one of the plurality of data leads. The inorganic composite insulation layer is located in the signal access region, and the inorganic composite insulation layer is located on a side of at least one contact pad metal layer of the plurality of contact pad metal layers close to the base substrate. The first organic insulation layer is located in the signal access region, and the first organic insulation layer is located on a side of the inorganic composite insulation layer and at least one contact pad metal layer of the plurality of contact pad metal layers away from the base substrate. A side edge of the inorganic composite insulation layer is in contact with the first organic insulation layer or one of the plurality of contact pad metal layers.

In some exemplary embodiments, the inorganic composite insulation layer is located on a side of the plurality of contact pad metal layers close to the base substrate, and an orthographic projection of the inorganic composite insulation layer on the base substrate covers orthographic projections of overlapping regions of the plurality of contact pad metal layers on the base substrate.

In some exemplary embodiments, the at least one contact pad further includes an inactive contact pad metal layer, and the inorganic composite insulation layer is located between the plurality of contact pad metal layers and the inactive contact pad metal layer of the at least one contact pad.

Relevant description of the display panel of the present embodiment may refer to the descriptions in the aforementioned embodiments, and thus will not be repeated here.

FIG. 23 is a schematic view of a display device according to at least one embodiment of the present disclosure. As shown in FIG. 23, the embodiment provides a display device 91 including a display panel 910 of the aforementioned embodiments. In some examples, the display panel 910 may be an OLED display panel with an integrated touch structure. The display device 91 may be any product or component with a display and touch function, such as a mobile phone, a tablet computer, a television, a display, a laptop, a digital photo frame, or a navigator.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. Those of ordinary skills in the art should understand that modifications or equivalent replacements may be made to the technical solutions of the present disclosure without departing from the essence and scope of the technical solutions of the present disclosure, and shall all fall within the scope of the claims of the present disclosure.

## Claims

1. A display panel, comprising:
a base substrate, comprising a display region and a signal access region located on at least one side of the display region;
a display structure layer located on the base substrate of the display region, wherein the display structure layer comprises a plurality of sub-pixels and a plurality of data lines electrically connected to the plurality of sub-pixels, the plurality of data lines are configured to provide data signals to the plurality of sub-pixels;
a plurality of data leads located in the signal access region, wherein the plurality of data leads are connected to the plurality of data lines;
a plurality of contact pads located in the signal access region, wherein at least one contact pad of the plurality of contact pads comprises a plurality of contact pad metal layers electrically connected to each other, the plurality of contact pad metal layers are electrically connected to one of the plurality of data leads; and
an inorganic composite insulation layer located in the signal access region, wherein the inorganic composite insulation layer is located on a side of at least one contact pad metal layer of the plurality of contact pad metal layers close to the base substrate;
wherein an orthographic projection of the inorganic composite insulation layer on the base substrate does not overlap with orthographic projections of the plurality of contact pads on the base substrate, or the orthographic projection of the inorganic composite insulation layer on the base substrate at least partially overlaps with an orthographic projection of the at least one contact pad on the base substrate.

2. The display panel according to claim 1, wherein the inorganic composite insulation layer is located on a side of the plurality of contact pad metal layers close to the base substrate.

3. The display panel according to claim 2, wherein the orthographic projection of the inorganic composite insulation layer on the base substrate covers orthographic projections of overlapping regions of the plurality of contact pad metal layers on the base substrate.

4. The display panel according to claim 2, wherein at least a part of the inorganic composite insulation layer is located in a gap between adjacent contact pads.

5. The display panel according to claim 2, wherein the at least one contact pad further comprises an inactive contact pad metal layer; and the inorganic composite insulation layer is located between the plurality of contact pad metal layers and the inactive contact pad metal layer of the at least one contact pad.

6. The display panel according to claim 5, wherein the orthographic projection of the inorganic composite insulation layer on the base substrate covers an orthographic projection of the inactive contact pad metal layer on the base substrate.

7. The display panel according to any one of claims 2 to 6, wherein the at least one contact pad comprises a first contact pad metal layer in contact with a surface of the inorganic composite insulation layer away from the base substrate; and the first contact pad metal layer is electrically connected to one data lead.

8. The display panel according to claim 7, wherein the first contact pad metal layer and the one data lead are of an integral structure connected to each other.

9. The display panel according to claim 7, further comprising: a plurality of access connection lines located in the signal access region;
wherein the first contact pad metal layer is electrically connected to the data lead through one access connection line; and the first contact pad metal layer and the one access connection line are of an integral structure connected to each other.

10. The display panel according to claim 9, wherein a connection position of the access connection line and the data lead is located on a side of the plurality of contact pads close to the display region.

11. The display panel according to claim 9 or 10, further comprising: a plurality of connection electrodes located in the signal access region;
wherein the access connection line is electrically connected to the data lead through a connection electrode; the access connection line is located on a side of the data lead away from the base substrate; and the connection electrode is located on a side of the access connection line away from the base substrate.

12. The display panel according to any one of claims 1 to 11, wherein at least one sub-pixel of the plurality of sub-pixels comprises a pixel circuit; the pixel circuit comprises at least one first transistor, and at least one second transistor; and the first transistor and the second transistor are of different transistor types;
the first transistor comprises a first active layer and a first gate;
the second transistor comprises a second active layer and a second gate; the first active layer and the first gate of the first transistor are located on a side of the second active layer of the second transistor close to the base substrate; and the second gate is located on a side of the second active layer away from the base substrate;
a third gate insulation layer is provided between the second active layer and the second gate; and
the inorganic composite insulation layer at least comprises a fifth inorganic insulation layer arranged in the same layer as the third gate insulation layer.

13. The display panel according to claim 12, wherein the pixel circuit further comprises at least one capacitor; the capacitor comprises a first plate and a second plate; and the second plate is located on a side of the first plate away from the base substrate and located on the side of the second active layer of the second transistor close to the base substrate;
a first interlayer insulation layer is provided between the second plate and the second active layer of the second transistor; and
the inorganic composite insulation layer comprises the fifth inorganic insulation layer and a third inorganic insulation layer arranged in the same layer as the first interlayer insulation layer.

14. The display panel according to claim 13, wherein a first buffer layer is further provided between the second plate and the second active layer of the second transistor, and the first interlayer insulation layer is located on a side of the first buffer layer close to the base substrate; and
the inorganic composite insulation layer comprises the third inorganic insulation layer, the fifth inorganic insulation layer, and a fourth inorganic insulation layer arranged in the same layer as the first buffer layer.

15. The display panel according to claim 12, wherein the at least one contact pad comprises a first contact pad metal layer in contact with a surface of the inorganic composite insulation layer away from the base substrate; and the first contact pad metal layer and the second gate of the second transistor are structures arranged in a same layer.

16. The display panel according to claim 15, wherein the at least one contact pad further comprises a second contact pad metal layer located on a side of the first contact pad metal layer away from the base substrate;
the display panel further comprises a sixth inorganic insulation layer located in the signal access region and located on a side of the fifth inorganic insulation layer away from the base substrate; and
an orthographic projection of the sixth inorganic insulation layer on the base substrate does not overlap with the orthographic projection of the at least one contact pad on the base substrate; or, the sixth inorganic insulation layer covers an edge of the first contact pad metal layer of the at least one contact pad, and a surface of the first contact pad metal layer exposed by the sixth inorganic insulation layer is in contact with the second contact pad metal layer.

17. The display panel according to claim 16, wherein a part of the sixth inorganic insulation layer is disposed in a gap between adjacent contact pads.

18. The display panel according to claim 16, wherein the sixth inorganic insulation layer has an annular structure covering the edge of the first contact pad metal layer.

19. The display panel according to claim 16, wherein the second transistor further comprises a second source and a second drain, and a second interlayer insulation layer is provided between the second gate of the second transistor and the second source and second drain of the second transistor;
the sixth inorganic insulation layer is arranged in the same layer as the second interlayer insulation layer; and
the second contact pad metal layer and the second source and the second drain of the second transistor are structures arranged in a same layer.

20. The display panel according to claim 1, wherein the at least one contact pad comprises a first contact pad metal layer located on a side of the inorganic composite insulation layer close to the base substrate, and a second contact pad metal layer located on a side of the inorganic composite insulation layer away from the base substrate, and the second contact pad metal layer is connected to the first contact pad metal layer; and
the inorganic composite insulation layer covers an edge of the first contact pad metal layer.

21. The display panel according to claim 20, wherein the inorganic composite insulation layer has an annular structure covering the edge of the first contact pad metal layer.

22. The display panel according to any one of claims 12 to 21, wherein the at least one sub-pixel further comprises a light emitting element, and the pixel circuit is electrically connected to the light emitting element through a first transfer electrode;
the at least one contact pad comprises a first contact pad metal layer, a second contact pad metal layer, and a third contact pad metal layer sequentially arranged along a direction away from the base substrate; and
the third contact pad metal layer and the first transfer electrode are structures arranged in a same layer.

23. The display panel according to claim 22, further comprising: a touch structure layer located on a side of the display structure layer away from the base substrate, wherein the touch structure layer comprises at least one touch conductive layer; and
the at least one contact pad further comprises a fourth contact pad metal layer located on a side of the third contact pad metal layer away from the base substrate, and the fourth contact pad metal layer and one touch conductive layer of the touch structure layer are structures arranged in a same layer.

24. The display panel according to claim 22 or 23, wherein a side edge of the inorganic composite insulation layer is in contact with the second contact pad metal layer or the third contact pad metal layer.

25. The display panel according to any one of claims 1 to 24, further comprising: a first organic insulation layer located in the signal access region and located on a side of the inorganic composite insulation layer away from the base substrate; wherein a side edge of the inorganic composite insulation layer is in contact with the first organic insulation layer.

26. A display device, comprising the display panel according to any one according to claims 1 to 25.

27. A manufacturing method for a display panel, comprising:
providing a base substrate comprising a display region and a signal access region located on at least one side of the display region;
forming a display structure layer in the display region, and forming a plurality of data leads, a plurality of contact pads and an inorganic composite insulation layer in the signal access region; wherein the display structure layer comprises a plurality of sub-pixels and a plurality of data lines, the plurality of sub-pixels and the plurality of data lines are electrically connected, the plurality of data lines are configured to provide data signals to the plurality of sub-pixels; the plurality of data leads are connected to the plurality of data lines; at least one contact pad of the plurality of contact pads comprises a plurality of contact pad metal layers electrically connected to each other, and the plurality of contact pad metal layers are electrically connected to one of the plurality of data leads; and
wherein the inorganic composite insulation layer is located on a side of at least one contact pad metal layer of the plurality of contact pad metal layers close to the base substrate; an orthographic projection of the inorganic composite insulation layer on the base substrate does not overlap with orthographic projections of the plurality of contact pads on the base substrate, or the orthographic projection of the inorganic composite insulation layer on the base substrate at least partially overlaps with an orthographic projection of the at least one contact pad on the base substrate.

28. A display panel, comprising:
a base substrate, comprising a display region and a signal access region located on at least one side of the display region;
a display structure layer located on the base substrate of the display region, wherein the display structure layer comprises a plurality of sub-pixels and a plurality of data lines electrically connected to the plurality of sub-pixels, the plurality of data lines are configured to provide data signals to the plurality of sub-pixels;
a plurality of data leads located in the signal access region, wherein the plurality of data leads are connected to the plurality of data lines;
a plurality of contact pads located in the signal access region, wherein at least one contact pad of the plurality of contact pads comprises a plurality of contact pad metal layers electrically connected to each other, and the plurality of contact pad metal layers are electrically connected to one of the plurality of data leads;
an inorganic composite insulation layer located in the signal access region, wherein the inorganic composite insulation layer is located on a side of at least one contact pad metal layer of the plurality of contact pad metal layers close to the base substrate; and
a first organic insulation layer located in the signal access region, wherein the first organic insulation layer is located on a side of the inorganic composite insulation layer and the at least one contact pad metal layer of the plurality of contact pad metal layers away from the base substrate;
wherein a side edge of the inorganic composite insulation layer is in contact with the first organic insulation layer or one of the plurality of contact pad metal layers.

29. The display panel according to claim 28, wherein the inorganic composite insulation layer is located on a side of the plurality of contact pad metal layers close to the base substrate, and an orthographic projection of the inorganic composite insulation layer on the base substrate covers orthographic projections of overlapping regions of the plurality of contact pad metal layers on the base substrate.

30. The display panel according to claim 28, wherein the at least one contact pad further comprises an inactive contact pad metal layer; and the inorganic composite insulation layer is located between the plurality of contact pad metal layers and the inactive contact pad metal layer of the at least one contact pad.
